(19) Europäisches Patentamt
European Patent Office
Office européen des brevets

(11) **EP 2 018 673 B1**

(12) # EUROPÄISCHE PATENTSCHRIFT

(45) Veröffentlichungstag und Bekanntmachung des Hinweises auf die Patenterteilung:
**08.01.2014 Patentblatt 2014/02**

(21) Anmeldenummer: **07725309.4**

(22) Anmeldetag: **16.05.2007**

(51) Int Cl.:
*H01L 41/09* (2006.01)      *H01L 41/047* (2006.01)
*H01H 57/00* (2006.01)      *H01G 5/18* (2006.01)
*F04B 43/04* (2006.01)

(86) Internationale Anmeldenummer:
**PCT/EP2007/004394**

(87) Internationale Veröffentlichungsnummer:
**WO 2007/131796 (22.11.2007 Gazette 2007/47)**

(54) **MIKROMECHANISCHE AKTOREN AUS HALBLEITERVERBINDUNGEN AUF BASIS VON NITRIDEN VON HAUPTGRUPPE-III-ELEMENTEN**

MICROMECHANICAL ACTUATORS CONSISTING OF SEMICONDUCTORS BASED ON GROUP III NITRIDES

ACTIONNEURS MICROMÉCANIQUES EN SEMI-CONDUCTEURS À BASE DE NITRURES DU GROUPE III

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **17.05.2006 DE 102006022940**

(43) Veröffentlichungstag der Anmeldung:
**28.01.2009 Patentblatt 2009/05**

(73) Patentinhaber: **MicroGaN GmbH**
**89081 Ulm (DE)**

(72) Erfinder:
• **KUNZE, Mike**
**89284 Pfaffenhoffen (DE)**
• **DAUMILLER, Ingo**
**88451 Dettingen (DE)**

(74) Vertreter: **Witte, Weller & Partner**
**Königstrasse 5**
**70173 Stuttgart (DE)**

(56) Entgegenhaltungen:
| | |
|---|---|
| EP-A- 1 617 464 | WO-A-2004/083110 |
| US-A- 5 631 463 | US-A1- 2002 067 992 |
| US-A1- 2003 119 220 | US-A1- 2005 099 236 |
| US-A1- 2005 194 867 | US-A1- 2005 242 687 |
| US-A1- 2006 055 287 | US-A1- 2007 228 887 |

• **DAVIES S ET AL: "Fabrication of GaN cantilevers on silicon substrates for microelectromechanical devices" APPLIED PHYSICS LETTERS, AIP, AMERICAN INSTITUTE OF PHYSICS, MELVILLE, NY, US, Bd. 84, Nr. 14, 5. April 2004 (2004-04-05), Seiten 2566-2568, XP012060996 ISSN: 0003-6951**
• **MILLS A: "Nitrides in Europe" III VS REVIEW, ELSEVIER SCIENCE PUBLISHERS, OXFORD, GB, Bd. 17, Nr. 8, November 2004 (2004-11), Seiten 36-38, XP004648733 ISSN: 0961-1290**

Bemerkungen:
Die Akte enthält technische Angaben, die nach dem Eingang der Anmeldung eingereicht wurden und die nicht in dieser Patentschrift enthalten sind.

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Der vorliegenden Erfindung liegt die Aufgabe zugrunde, freistehende bzw. freitragenden mikromechanische Bauelemente zur Verfügung zu stellen, welche sich nicht nur auf einfache Art und Weise mittels herkömmlicher Verfahren strukturieren lassen, sondern welche sich auch gegenüber den aus dem Stand der Technik bekannten Bauelementen durch einen einfachen Aufbau, durch ein hohes Eingangssignal-Auslenkungsverhältnis und durch variable Einsatzmöglichkeiten (beispielsweise auch unter hohen Temperaturen) auszeichnen.

Aus der WO 2004/083110 A2 ist ein Sensorelement bekannt, das eine Halbleiterstruktur auf Gruppe III-Nitritbasis aufweist. Das Sensorelement dient der Bestimmung des Drucks, der Temperatur, einer Kraft, einer Auslenkung oder einer Beschleunigung.

Zudem zeigt die US 2003/0119220 A1 ein mikromechanisches Element, das eine mikromechanische Struktur aus einem einzelnen Kristall aufweist. Zumindest ein Abschnitt der mikromechanischen Struktur ist befähigt, eine mechanische Bewegung durchzuführen.

Die Aufgabe wird durch einen Halbleiteraktor gemäß Anspruch 1 gelöst. Vorteilhafte Weiterbildungen des erfindungsgemäßen Halbleiteraktors sind in den jeweiligen abhängigen Ansprüchen beschrieben. Erfindungs-gemäße Verwendungen eines solchen Halbleiteraktors finden sich in Anspruch 13.

Die vorliegende Erfindung beschreibt Aktoren, welche Halbleiterstrukturen auf Gruppe-III-Nitridbasis (beispielsweise aus GaN, AlN oder InN) aufweisen. Durch Anlegen einer Spannung an die Halbleiterstruktur oder durch Einprägen eines Stroms in die Halbleiterstruktur setzen die erfindungsgemäßen Elemente eine Änderung der elektrischen Eingangsgröße mittels ihrer piezoelektrischen Eigenschaften in eine Änderung einer anderen physikalischen Größe, hier die Bewegung, um.

Die Erfindung betrifft dabei insbesondere mikromechanische Aktoren, d.h. Aktoren, die oder deren einzelne Bauelemente eine Größe im Bereich von wenigen 10 nm bis einige 100 $\mu$m, ggf. auch darüber, aufweisen. Die erfindungsgemäßen Aktoren sind somit MEMS-Bauelemente, wobei die Abkürzung MEMS für mikroelektromechanische Systeme steht. Hier wie im folgenden wird die Bezeichnung Gruppe-III bzw. Hauptgruppe-III als Abkürzung für die dritte Hauptgruppe des Periodensystems der Elemente verwendet. Unter dem Begriff einer homogenen Halbleiterschicht wird im folgenden eine im gesamten Schichtvolumen einheitlich aus einem Halbleitermaterial auf Gruppe-III-Nitridbasis aufgebaute Schicht verstanden. Im Gegensatz hierzu weist eine Halbleiter-Heterostruktur mindestens zwei auf-oder aneinander angeordnete homogene Halbleiterschichten auf (beispielsweise AlGaN/GaN-Heterostruktur: AlGaN-Schicht auf GaN-Schicht). Unter einem freitragenden Element (z.B. freitragender Balken) wird nachfolgend ein Element verstanden, welches abschnittsweise mit einer Substratbasis verbunden ist (Ankerpunkt oder Ankerpunkte) und abschnittsweise nicht mit dem Substrat verbunden ist, sondern beabstandet vom Substrat (beispielsweise über einen Hohlraum zwischen Element und Substrat beabstandet) angeordnet ist. Unter einem freistehenden Element wird ein freitragendes Element verstanden (beispielsweise freitragender Balken), welches nur genau an einer Seite bzw. an einem Ende einen (oder ggf. auch mehrere) Anker hat und an seiner gegenüberliegenden Seite bzw. am anderen Ende keinen Ankerpunkt hat, in diesem Bereich also freitragend ist (beispielsweise einseitig eingespannter Balken).

Im Vergleich zu klassischen Materialien in der Aktor-Technologie wie Silizium liegen bei Materialsystemen, welche auf Basis von Nitriden von Hauptgruppe-III-Elementen realisiert werden, erstmals Halbleiter vor, welche eine starke Polarität aufweisen. Solche Strukturen zeichnen sich somit gegenüber herkömmlichen Strukturen durch ausgeprägte piezoelektrische Eigenschaften aus, welche in der mechanischen Aktorik verwendet werden können. Zur Einprägung des Stroms bzw. zur Anlegung der notwendigen Spannung können hierbei insbesondere unmittelbare Kontaktierungen an Grenzflächen von Heterostrukturen (beispielsweise AlGaN/GaN) eingesetzt werden, wie dies nachfolgend noch ausführlich beschrieben wird. Eine über den Kristall gleichgerichtete und von der Verspannung im Material abhängige Polarisation bzw. die hohe Ladungsträgerdichte an der Oberfläche einer solchen Halbleiterstruktur und insbesondere auch an der Grenzfläche zwischen zwei solchen Halbleiterstrukturen einer Halbleiter-Heterostruktur wird erfindungsgemäß beispielsweise durch unmittelbare Kontaktierung der Grenzfläche mit einem elektrischen Kontakt als Elektrode genutzt. Die (hohe) Ladungsträgerdichte an einer solchen Heterostruktur-Grenzfläche wird nachfolgend auch als 2D-Elektronengas (2DEG) bezeichnet. Die Ausnutzung der Eigenschaften einer Heterostruktur bzw. der Heterostrukturgrenzfläche (auch als Heterostrukturkanal bezeichnet) erfolgt erfindungsgemäß zur Realisierung einer erfindungsgemäßen Aktorstruktur. Es hat sich gezeigt, dass prinzipiell auch mit homogenen Halbleiterschichten (beispielsweise aus undotiertem oder dotiertem GaN) ein ausreichend hohes Eingangssignal-Auslenkungs-Verhältnis erzielt werden könnte.

Die piezoelektrischen Material-eigenschaften können erfindungsgemäß dazu verwendet werden, Strukturen herzustellen, die ohne eine Dotierung mit Fremdatomen auskommen, um die Leitfähigkeit zu ermöglichen. Ebenso ist jedoch auch die Kombination mit einer Dotierung möglich (p- oder n-Dotierung beispielsweise des Volumenmaterials zur besseren Kontaktierung). Da die Piezoeigenschaften des Materials die freien Ladungsträger in den Volumenmaterialien beeinflussen, wird erfindungsgemäß die Manipulation der Piezoeigenschaften durch Anlegen einer Spannung bzw. durch Einprägen eines Stroms in die Materialien zur Erstellung von Aktorbauelementen verwendet. Die auf bearbeitbaren Substraten hergestellten Bauelemente werden erfindungsgemäß vorteilhafterweise partiell oder vollständig vom Substrat freigelegt (freitragende oder freistehende Strukturen).

Durch eine elektrische Anregung von freistehenden und freitragenden Biegestrukturen auf Basis von Halbleiterverbindungen von Hauptgruppe-III-Elementen (beispielsweise freistehende Balken) erfolgt aufgrund der piezoelektrischen Eigenschaften der verwendeten Materialien somit eine Auslenkung dieser Biegestrukturen, welche erfindungsgemäß beispielsweise die Realisierung von mikromechanischen Schaltern oder auch von Varaktoren ermöglicht. Solche Schalter oder Varaktoren können dann insbesondere in der Hochfrequenz-MEMS-Technologie (beispielsweise in der Telekommunikation) Anwendung finden.

Die wesentliche Grundlage für die Herstellung erfindungsgemäßer Halbleiteraktoren stellt eine gute technologische Bearbeitbarkeit des verwendeten Substratmaterials dar. Aus diesem Grund kommen in der vorliegenden Erfindung vorteilhafterweise Siliziummaterialien als Substratbasis zum Einsatz. Die Realisierung der die Halbleiterverbindungen auf Basis von Nitriden von Hauptgruppe-III-Elementen enthaltenden MEMS auf einem Siliziumsubstrat erfolgt, wie nachfolgend noch genauer beschrieben, mittels, Strukturierung und Prozessierung eines epitaktisch hergestellten Wafers (beispielsweise CVD-Verfahren oder PVD-Verfahren). Anders als bei der klassischen Herstellung von MEMS-Bauelementen findet bei den erfindungsgemäßen MEMS-Bauelementen kein Aufbau bzw. keine Strukturierung der freitragenden oder freistehenden Strukturen mit Hilfe von Fremdmaterialien statt. Werden beispielsweise im Stand der Technik Strukturen mit Hilfe von dielektrischen Schichten und galvanisierten Metallen hergestellt, so ist im Falle der erfindungsgemäßen MEMS-Technologie das Halbleitermaterial selbst der Aktor im MEMS-Bauelement.

Die vorliegende Erfindung wird nun nachstehend zunächst allgemein beschrieben; dem schließt sich eine Mehrzahl von einzelnen Ausführungsbeispielen zur konkreten technischen Realisierung an. Einzelne erfindungsgemäße Merkmale können hierbei jedoch nicht nur in einer Kombination, wie sie in den speziellen vorteilhaften Ausführungsbeispielen gezeigt ist, auftreten, sondern können im Rahmen der vorliegenden Erfindung auch in beliebigen anderen Kombinationen ausgebildet sein und/oder verwendet werden.

Erfindungsgemäße MEMS-Bauelemente mit Halbleiterverbindungen auf Basis von Nitriden von Hauptgruppe-III-Elementen weisen gegenüber den aus dem Stand der Technik bekannten Bauelementen die folgenden Vorteile auf:

- Die ausgeprägten Polarisationseigenschaften der verwendeten Halbleitermaterialien ermöglichen ein hohes Eingangssignal-Auslenkungs-Verhältnis und tragen somit wesentlich zur Funktion der erfindungsgemäßen Aktoren bei. Weiterhin ergibt sich aus der großen Bandlücke der Halbleitermaterialien eine hohe Temperaturstabilität, was den Einsatz bei erhöhten Betriebstemperaturen ermöglicht.

- In Kombination mit den polaren Eigenschaften des Halbleitermaterials auf Basis von Nitriden von Hauptgruppe-III-Elementen (nachfolgend nun alternativ und abgekürzt auch als Ga/Al/In-Nitrid bezeichnet) erlauben die weiteren Eigenschaften des Materials ein Betrieb der Bauelemente auch bei hohen Einsatzspannungen bzw. bei großen elektrischen Verlustleistungen.

- Aufgrund der piezoelektrischen Eigenschaften des Materials ist eine lineare Auslenkung der Ga/Al/In-Nitrid-basierenden mikromechanischen Elemente in Abhängigkeit von einer äußeren elektrischen Anregung möglich. Dadurch ist die Möglichkeit gegeben eine veränderbare Kapazität (Varaktor) mit sehr großem $C_{min}/C_{max}$-Verhältnis zu realisieren. Es kann eine Variation der elektrischen Kenngrößen (Kapazität) über den gesamten möglichen Auslenkungshub des Aktors reproduzierbar eingestellt werden.

- Im Vergleich zu den herkömmlichen Technologien weisen die Ga/Al/In-Nitrid-basierten erfindungsgemäßen Elemente eine größere Leistungsdichte, höhere erlaubte Betriebsspannungen bzw. Betriebsströme sowie erhöhte erlaubte Betriebstemperaturen auf.

- Erfindungsgemäße MEMS-Bauelemente zeichnen sich gegenüber denjenigen konventioneller Technologie insbesondere durch folgende Eigenschaften aus: eine kleine Einfügedämpfung, eine hohe Isolation, ihre Linearität, eine große Frequenzbandbreite, eine kleine Bauelementgröße, geringe Parasitärströme, schnelle Schaltzeiten, sehr hohe Strom- und Spannungsfestigkeit, große Gleichstrom- und Hochspannungs-Leistungsaufnahme und -leistungsbelastbarkeit, hohe Temperatur- und Langzeitstabilität, ihre Eignung für hohe Umgebungstemperaturen, eine große Auslenkungsstrecke bzw. einen großen Hub des Schalters, ein sehr hohes $C_{min}/C_{max}$-Verhältnis (beim Varaktor) und eine große Piezopolarisation des Materials.

Nachfolgend werden vorteilhafte Ausführungsformen der erfindungsgemäßen Halbleiteraktoren kurz beschrieben. Die nun nachfolgend aufgezählten Merkmale können einzeln, also unabhängig voneinander, jedoch ebenso gut auch in Kombination miteinander im Rahmen der vorliegenden Erfindung verwirklicht sein.

Erfindungsgemäße Halbleiteraktoren können somit die Eigenschaft haben, dass

- die Biegestruktur mindestens einen Balken, insbesondere einen freitragenden und/oder freistehenden Balken, aufweist,
- mindestens einer der elektrischen Zuleitungskontakte zumindest teilweise auf der der Substratbasis abgewandten Seite der Biegestruktur (Oberseite der Biegestruktur) angeordnet ist und/oder dass mindestens einer der elektrischen Zuleitungskontakte zumindest teilweise auf der der Substratbasis zugewandten Seite der Biegestruktur (Unterseite der Biegestruktur) angeordnet ist und/oder dass mindestens einer der elektrischen Zuleitungskontakte zumindest teilweise in der Biegestruktur integriert, insbesondere zwischen der Oberseite und der Unterseite der Biegestruktur in diese integriert, angeordnet ist,

- ein zumindest teilweise auf der Oberseite der Biegestruktur und ein zumindest teilweise auf der Unterseite der Biegestruktur angeordneter elektrischer Zuleitungskontakt oder ein zumindest teilweise auf der Oberseite der Biegestruktur und ein zumindest teilweise in der Biegestruktur integriert angeordneter elektrischer Zuleitungskontakt oder ein zumindest teilweise auf der Unterseite der Biegestruktur und ein zumindest teilweise in der Biegestruktur integriert angeordneter elektrischer Zuleitungskontakt vorhanden ist,

- der in der Biegestruktur zumindest teilweise integriert angeordnete elektrische Zuleitungskontakt die Heterostruktur-Grenzfläche umfasst,

- mindestens zwei der Zuleitungskontakte beabstandet voneinander auf der Oberseite der Biegestruktur angeordnet sind,

- die Substratbasis Silizium Si enthält oder daraus besteht,

- die Substratbasis ein 111-Si-Substrat aufweist oder dass die Substratbasis ein 100-Si-Substrat und/oder ein 110-Si-Substrat aufweist,

- das Kontaktelement ein Metall und/oder eine Legierung und/oder eine lichtreflektierende Schicht aufweist,

- dass die Halbleiter-Heterostruktur eine erste Struktur aus GaN, InN, oder AlN und eine zweite Struktur aus $Al_xGa_{1-x}N$, $In_xGa_{1-x}N$ oder $In_xAl_{l1-x}N$ aufweist, wobei bevorzugt die erste Struktur auf der der Substratbasis zugewandten Seite und die zweite Struktur auf der der Substratbasis abgewandten Seite angeordnet ist und/oder wobei bevorzugt die erste und die zweite Struktur aneinander angrenzend angeordnet sind,

- die zweite Struktur aus $Al_xGa_{1-x}N$, bevorzugt mit $0.1 <= x <= 0.3$, insbesondere bevorzugt mit $0.15 <= x <= 0.25$, besteht oder dass die zweite Struktur aus AlN besteht und/oder dass die erste Struktur aus GaN besteht,

- die zweite Struktur aus AlN besteht, dass die erste Struktur aus GaN besteht und dass zwischen der zweiten und der ersten Struktur eine Zwischenschicht angeordnet ist,

- die Zwischenschicht ein Halbleitermaterial enthält oder daraus besteht, wobei die Zwischenschicht bevorzugt als eine AlN und GaN aufweisende Schicht ausgebildet ist, in der in Richtung von der ersten Struktur zur zweiten Struktur der AlN-Anteil zunimmt,

- die Ausdehnung der zweiten Struktur in einer Richtung im wesentlichen senkrecht zu ihrer der Substratbasis zugewandten Oberfläche im Bereich von über 5 nm und/oder unter 1000 nm, insbesondere im Bereich von über 10 nm und/oder unter 200 nm liegt,

- die der Substratbasis abgewandte Seite der Halbleiter-Heterostruktur als die mechanisch verspannte Schicht ausgebildet ist,

- die Verspannung so ausgebildet ist, dass die Biegestruktur im Wesentlichen von der Substratbasis weg aus der Ruhelage auslenkbar ist oder im Wesentlichen zur Substratbasis hin aus der Ruhelage auslenkbar ist,

- die Biegestruktur zumindest teilweise undotiert, p-dotiert oder n-dotiert ist und/oder eine entsprechend dotierte Schicht aufweist,

- die der Dotierstoffgehalt größer 0 Atome pro $cm^3$ und/oder kleiner $10^{20}$ Atome pro $cm^3$ beträgt und/oder dass der Dotierstoff Silizium Si und/oder Magnesium Mg enthält oder daraus besteht und/oder dass die Dotierung eine Volumendotierung und/oder eine Pulsdotierung ist,

- der elektrische Kontakt einen Wellenleiter oder eine Kontaktbahn ausbildet,

- mindestens einer der elektrischen Zuleitungskontakte als legierter oder metallischer, nicht-legierter Ohmscher Kontakt oder als legierter oder nicht-legierter Schottky-Kontakt ausgebildet ist und/oder dass mindestens einer der elektrischen Zuleitungskontakte im Inneren der Biegestruktur durch Implantation ausgebildet ist und/oder dass mindestens einer der elektrischen Zuleitungskontakte ein p- oder ein n-Kontakt ist,

- die Biegestruktur im wesentlichen senkrecht zur mit der Substratbasis ausgebildeten Grenzfläche eine Dicke von über 0.2 $\mu$m und/oder unter 50 $\mu$m, insbesondere von über 0,5 $\mu$m und/oder unter 5 $\mu$m aufweist,

- mindestens zwei der Zuleitungskontakte über eine Stromquelle oder Spannungsquelle miteinander elektrisch verbunden sind,

- die Membran im Wesentlichen kreisförmig oder halbkreisförmig ist,

- zumindest ein Teilabschnitt der Oberfläche der Biegestruktur (2) mit einer adsorbierenden Beschichtung versehen ist.

Insbesondere kann erfindungsgemäß ein mikromechanischer Varaktor, ein mikromechanisches variables Spulenelement, ein mikromechanisches elektrisches Schaltelement oder eine mikromechanische Pumpe erfindungsgemäß ausgebildet werden, die/der/das einen erfindungsgemäßen Halbleiteraktor umfasst.

Ein erfindungsgemäßer Halbleiteraktor kann dann im Bereich der Mikromechanik oder im Bereich von Hochtemperaturanwendungen oder im Automotive-Bereich oder im Bereich von Telekommunikationsanwendungen oder im Bereich der Medizintechnik eingesetzt werden.

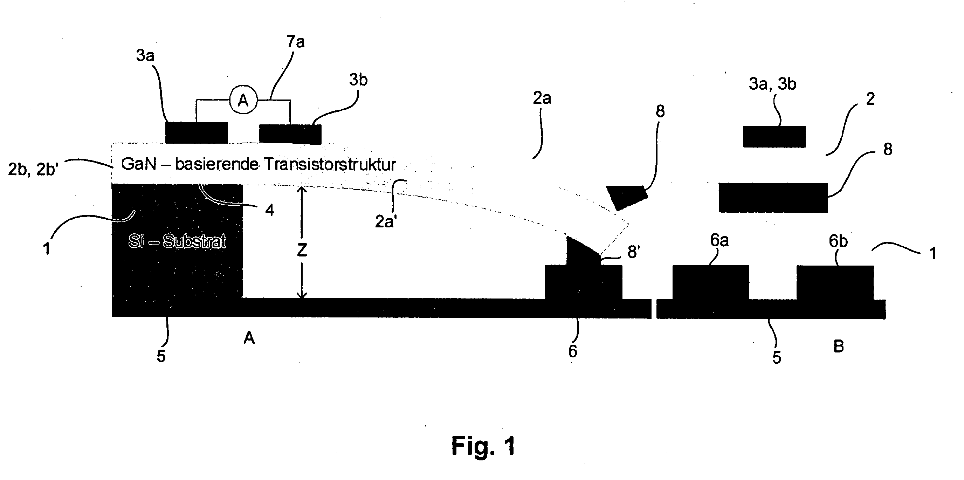

Die vorliegende Erfindung wird nun näher anhand einer Reihe von Ausführungsbeispielen beschrieben (Figuren 1 bis 20). Die nicht die Erfindung, sondern lediglich einzelne Aspekte der Erfindung und/oder Aspekte, die zum Verständnis der Erfindung notwendig sind, zeigenden Beispiele sind nachfolgend mit den Worten "zeigt nicht die Erfindung, aber" versehen.

Figur 1 zeigt nicht die Erfindung, aber einen elektrothermischen Halbleiteraktor in Form eines Schalters in schematischer Darstellung (Figur 1A: Seitenansicht im Schnitt entlang der Balkenlängsrichtung, Figur 1B: Frontansicht senkrecht dazu als Projektionsansicht; beide Ansichten in der Platinenebene gesehen). Auf einer Platine 5 ist abschnittsweise auf einer Seite ein Siliziumsubstrat 1, hier vereinfacht in Form eines Quaders gezeigt, aufgebracht. Auf der dem Siliziumsubstrat 1 gegenüberliegenden Seite ist auf der Platine ein elektrischer Kontakt in Form eines Wellenleiters 6 beabstandet vom Siliziumsubstrat 1 angeordnet. Auf der platinenabgewandten Seite trägt das

Siliziumsubstrat 1 eine Biegestruktur 2 in Form eines langgestreckten Balkens. Dieser langgestreckte Balken weist in Längsrichtung eine größere Ausdehnung auf, wie das Siliziumsubstrat, so dass der Balken 2 abschnittsweise (Abschnitt 2b, 2b') oberhalb des Siliziumsubstrats 1 angeordnet ist bzw. über einen Ankerpunkt 4 mit letzterem verbunden ist. Der seitlich über das Siliziumsubstrat 1 überstehende Abschnitt 2a, 2a' des Balkens 2 ist somit aufgrund des Zwischenraums Z zwischen Balken 2 und Platine 5 freistehen (lediglich ein Ankerpunkt an einer Balkenseite verbindet den Balken mit dem Siliziumsubstrat 1). An dem dem Siliziumsubstrat 1 gegenüberliegenden Ende des Balkens 2 trägt dieser auf seiner der Platine 5 zugewandten Unterseite einen elektrisch leitfähigen Metallstempel (Kontaktstempel 8). Das freistehende Ende des Balkens 2 endet oberhalb des Wellenleiters 6, so dass im nachfolgend näher beschriebenen Ruhezustand der Kontaktstempel 8 oberhalb des Wellenleiters 6 und beabstandet von diesem angeordnet ist.

Auf der dem Siliziumsubstrat abgewandten Seite (Oberseite) sind auf dem Balken 2 zwei elektrische Zuleitungskontakte 3a und 3b seitlich beabstandet nebeneinander angeordnet. Der erste Zuleitungskontakt 3a ist hierbei oberhalb des Siliziumsubstrats auf dem Balken angeordnet, also im Abschnitt 2b. Der zweite elektrische Zuleitungskontakt 3b ist oberhalb des freistehenden Abschnitts 2a des Balkens 2 auf diesem angeordnet. Die beiden elektrischen Zuleitungskontakte sind über eine Stromquelle 7a miteinander verbunden. Wie nachfolgend nun näher beschrieben, ist der Balken 2 im Ruhezustand (d.h. in dem Zustand, in dem kein Strom über die Stromquelle 7a und die Kontakte 3a, 3b in den Balken eingeprägt wird) nicht ausgelenkt, d.h. der Abschnitt 2a bildet den Abschnitt einer Geraden und verläuft in konstantem Abstand zur Platine 5. Bei Einprägen eines Stroms über die Quelle 7a in den Balken 2 biegt sich dieser, wie nachfolgend näher beschrieben, durch (Stellung 2a'), d.h. das dem Siliziumsubstrat 1 abgewandte freistehende Ende des Balkens nähert sich mit zunehmendem Stromfluss dem unterhalb dieses Endes angeordneten Wellenleiter 6, so dass bei ausreichender Stromstärke (Stellung 8') der Kontaktstempel 8 den elektrischen Kontakt zwischen den beiden Wellenleiterabschnitten 6a und 6b schließt und somit einen Stromfluss durch den Wellenleiter ermöglicht. Der Abschnitt 2b bleibt dabei nahezu unverändert in seiner Ausgangslage (Stellung 2b').

Somit zeigt Figur 1 eine nicht-erfindungsgemäße Ausführungsform eines Ga/Al/In-Nitrid-basierten Schalters.

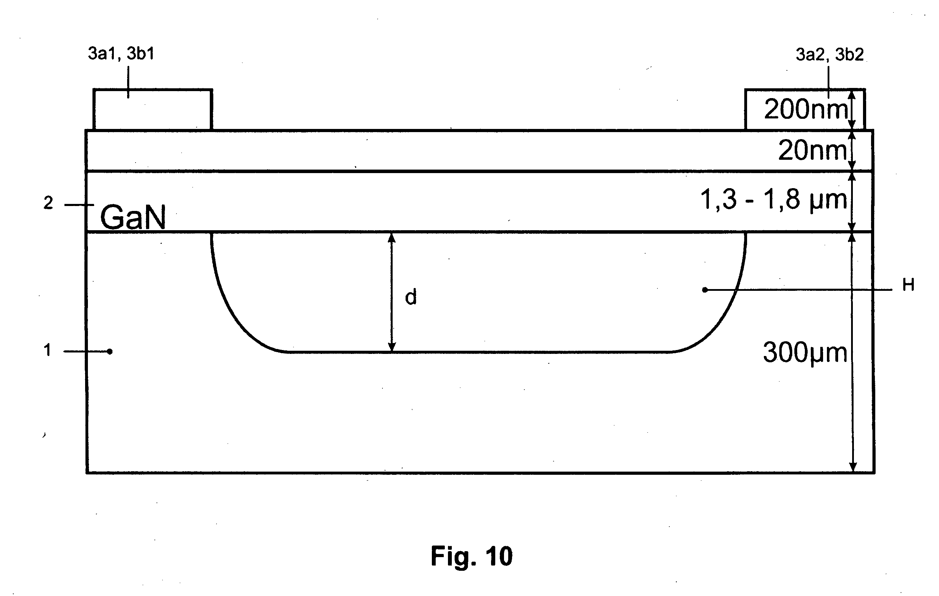

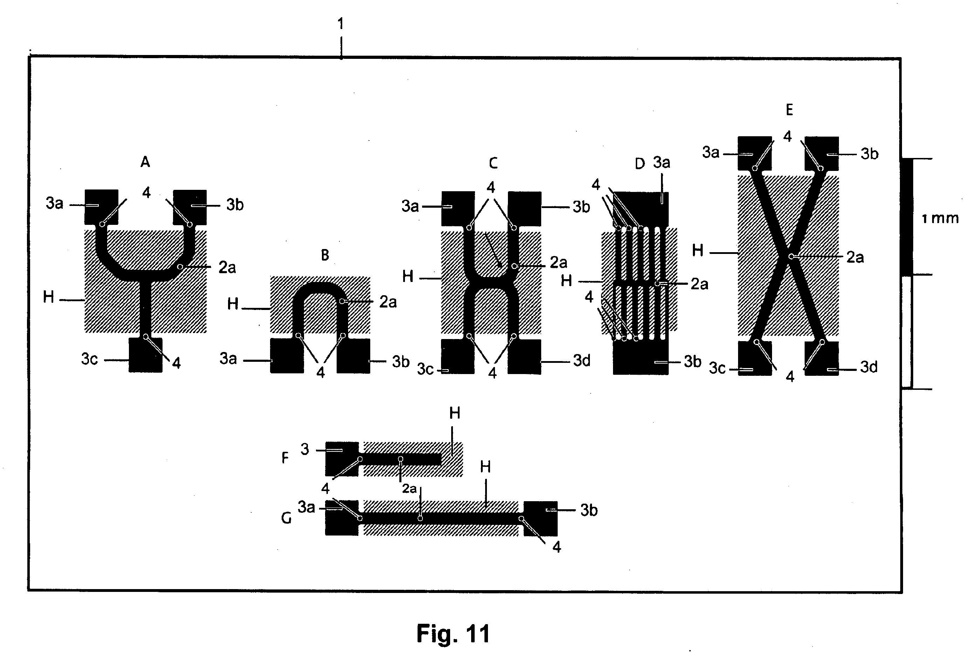

Eine Ga/Al/In-Nitrid-basierende Transistorstruktur 2 (in der Regel wird hier eine AlGaN/GaN-Heterostruktur mit einer Standard-Transistor-Schichtstruktur verwendet) wird epitaktisch auf einem Silizium-Substrat 1 gewachsen. Silizium-Substrat besitzt den Vorteil, dass es durch trockenchemisches Ätzverfahren zu bearbeiten ist und es freistehende Ga/Al/In-Nitrid-basierende Filme ermöglicht. Mit Hilfe von Ga/Al/In-Nitrid-typischen Technologie-Prozessen werden nun Wi-derstandselemente bzw. Zuleitungskontakte 3 hergestellt und durch einen Silizium-Rückseitenprozess (siehe Fig. 10 und 11) schlussendlich die freistehenden Balken 2a, 2b realisiert. Um diese Balkenstrukturen für Schaltzwecke nutzbar zu machen, ist noch der Kontaktstempel 8 am Ende des freistehenden Balkens notwendig. Der Kontaktstempel besteht aus einem Sandwich von einer hoch leitfähigen Schicht (Metall) und einer in Verbindung zur Ga/Al/In-Nitrid-basierenden Transistorstruktur liegenden, isolierenden Schicht.

Für die endgültige Funktion wird die Balkenstruktur 2 auf eine Leiterbahn bzw. Platine 5 plaziert (gebondet oder gelötet) auf der sich der Wellenleiter 6 oder alternativ eine Kontaktbahn befindet. Mit Hilfe dieses Schalters kann nun der Wellenleiter oder die Kontaktbahn kurzgeschlossen oder geöffnet werden.

Die Widerstandselemente 3 des Ga/Al/In-Nitrid-basierenden Schalters sind hierbei am Punkt mit der größten Verspannung, also an der Substratkante, plaziert (d.h. ein Kontakt im Bereich 2b, einer im Bereich 2a) und wirken dabei als piezoelektrische Widerstände. Im Ruhezustand, das bedeutet, das zwischen den Widerständen kein Potential anliegt bzw. kein Strom 7a in die Widerstände eingeprägt wird, ist der Balken gerade und symbolisiert hier den OFF-Zustand. Das bedeutet: die Verbindung in dem Wellenleiter 6 oder in der Kontaktbahn ist unterbrochen. Wird nun ein Strom in die piezoelektrischen Widerstandselemente eingeprägt so ändert sich aufgrund der lokalen thermischen Änderung (an der Oberseite bildet sich im Balken 2 ein im Vergleich zur Unterseite wärmerer Bereich im Balken) die Verspannung im Material und der Balken wird am freistehenden Ende nach unten ausgelenkt. Der Balken wandert in den ON-Zustand und schließt mit dem Kontaktstempel die Verbindung zum Wellenleiter oder zur Kontaktbahn.

Der entscheidende Vorteil für den Einsatz von solchen elektro-thermischen Ga/Al/In-Nitrid-basierenden Schaltern liegt in der Einfachheit des Aufbaus begründet. Mit der Basis einer Ga/Al/In-Nitrid-basierenden Transistorstruktur auf Silizium-Substrat, sei es eine HEMT-Struktur (High Electron Mobility Transistor) oder eine volumendotierte Variante (MESFET, Metal Semiconductor Fieldeffect Transistor) sind alle Komponenten, die zur Realisierung eines elektro-thermischen Aktors notwendig sind, bereits implementiert. Die polare Natur des Ga/Al/In-Nitrid-basierenden Materialsystems erlaubt die Herstellung piezoelektrischer Widerstände. Durch die Verwendung eines strukturierbaren Substratmaterials ist die Realisierung von Ga/Al/In-Nitrid-basierender Balkenstrukturen ohne externe Materialien und ohne zusätzliche Prozessschritte möglich.

Das Schaltverhalten des gezeigten elektrothermischen Ga/Al/In-Nitrid-basierenden Schalters ist abhängig von dem thermischen Ausdehnungskoeffizienten, der Geometrie, dem Elastizitätsmodul und der thermischen Leitfähigkeit des Balkens sowie von der Verlustleistung, die durch den eingeprägten Strom und den Widerstand des Piezoelementes 2 gegeben ist.

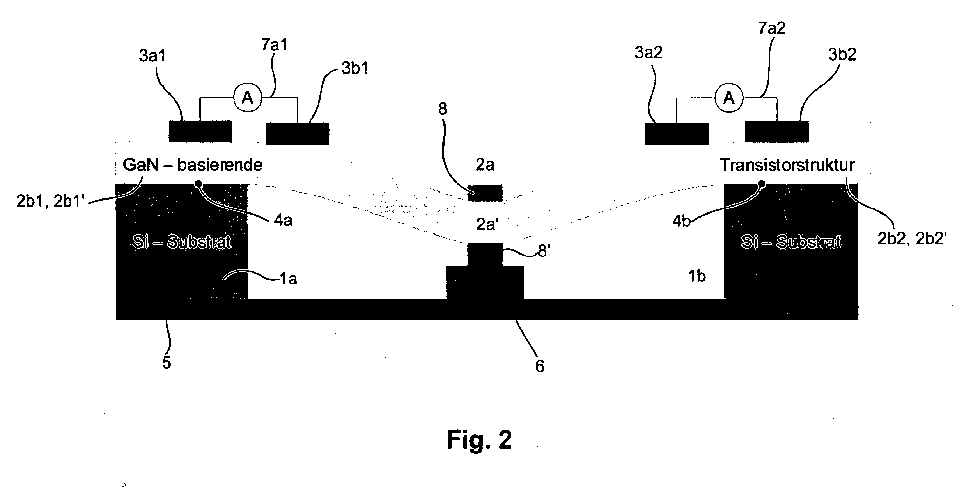

Figur 2 zeigt nun nicht die Erfindung, aber in Seitenansicht die schematische Darstellung eines elektrothermisch auslenkbaren Ga/Al/In-Nitrid-basierenden Schalters in einer Ausführungsform mit einem doppelt eingespannten (freitragenden, jedoch nicht mehr freistehenden) Balken. Wie die Figur zeigt, ist dieser Schalter wie zwei sich spiegelbildlich in einer Ebene senkrecht zu der Platine 5 auf Höhe des Kontaktstempels 8 gegenüberstehende Strukturen gemäß Figur 1 aufgebaut. Hierdurch ergibt sich ein Balken 2, der an zwei Ankerpunkten 4a und 4b auf zwei Siliziumsubstratabschnitten 1a bzw. 1b aufliegt (nicht freitragende Abschnitte 2b1 und 2b2 des Balkens) und dazwischen einen freitragenden Abschnitt 2a aufweist. Durch entsprechenden Stromfluss 7a1 und 7a2 lässt sich dieser Balken in der Mitte (wo er an seiner Unterseite den Kontaktstempel 8 trägt) zur Platine hin durchbiegen, wodurch (Stellung 8') wiederum der Kontakt zum Wellenleiter 6 geschlossen wird. Vorteil dieser gezeigten Konstruktionsvariante ist eine erhöhte mechanische Stabilität des nunmehr nicht mehr freistehenden, sondern nur noch freitragenden Balkens (Einspannen des Balkens an beiden gegenüberliegenden Enden). Der technologische Aufwand zur Herstellung dieser Variante ändert sich im Vergleich zur Herstellung der in Figur 1 gezeigten Variante nur unwesentlich.

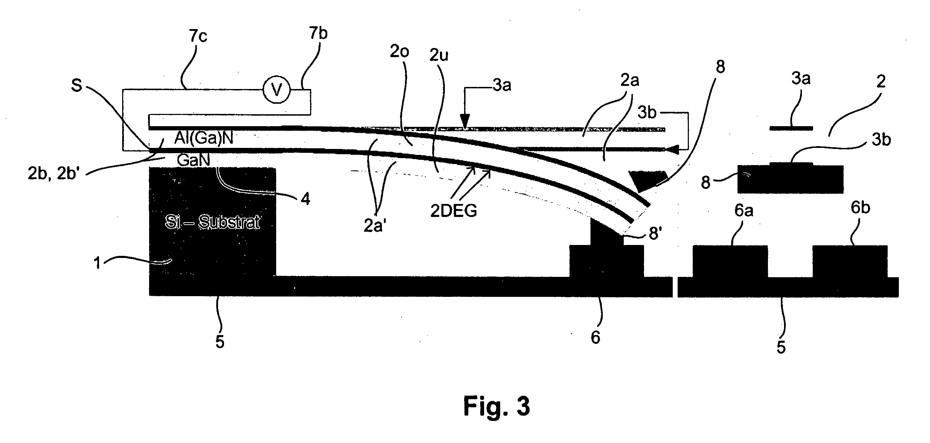

Figur 3 zeigt die Erfindung in Form einer schematischen Darstellung (analog der Ansichten in Figur 1; Figur 3A: Seitenansicht, Figur 3B: Frontansicht) eines elektrostatisch auslenkbaren Schalters auf Basis einer AlGaN/GaN-Heterostruktur. Der grundlegende Aufbau des gezeigten Schalters ist wie derjenige des in Figur 1 gezeigten Schalters, so dass nachfolgend nur die Unterschiede beschrieben werden. Die freistehende Balkenstruktur 2 ist hier als zweischichtige AlGaN/GaN-Heterostruktur ausgebildet: Auf einer ersten, der Platine 5 bzw. dem Siliziumsubstrat 1 zugewandten GaN-Schicht 2u ist eine zweite Schicht 2o aus AlGaN angeordnet. Wie nachfolgend noch näher beschrieben, ist der wesentliche Aspekt bei dieser Variante, dass die hohe Ladungsträgerdichte (2D-Elektronengas) 2DEG an der Heterostruktur-Grenzfläche zwischen diesen beiden Schichten 2o und 2u (bzw. im Heterostrukturkanal) unmittelbar, d.h. ohne Einbringung einer zusätzlichen Leiterschicht, dotierten Schicht oder ähnlichem als elektrischer Zuleitungskontakt bzw. als Elektrode 3b verwendet wird. Auf der Oberseite der obenliegenden AlGaN-Schicht 2o ist dann teil- oder vollflächig eine Metallschicht als zweite Elektrode bzw. zweiter elektrischer Zuleitungskontakt 3a aufgebracht. Die obenliegende AlGaN-Schicht 2o liegt somit sandwichförmig zwischen den beiden Flächenelektroden 3a und 3.b. An der Schmalseite bzw. Stirnseite S der Heterostrukturgrenzfläche 3b ist diese unmittelbar über einen metallischen Kontakt (Leitung 7c) mit einem Spannungsversorger 7b verbunden. Dieser Spannungsversorger verbindet die beiden Elektroden 3a und 3b und ermöglicht so das Anlegen eines elektrischen Feldes im Bereich der AlGaN-Deckschicht.

Insbesondere die starken Polarisationseffekte in Ga/Al/In-Nitrid-basierenden Heterostrukturen führen somit zur zweiten Variante der Ga/Al/In-Nitrid-basierenden Schalter. Das Grundprinzip ist gleich dem in Fig. 1 gezeigten. Eine einseitig eingespannte Balkenstruktur 2 wirkt als Schalter, der mit Hilfe eines Kontaktstempels 8 ein Wellenleiter 6 oder eine Kontaktbahn überbrücken (ON-Zustand) oder unterbrechen kann (OFF-Zustand). Die Technologie und die Wirkungsweise des in Fig. 3 dargestellten Ga/Al/In-Nitrid-basierenden Hochfrequenz- bzw. RF-Schalters unterscheidet sich allerdings deutlich von der elektrothermisch ausgelenkten Variante der Fig. 1.

Grundlage hierfür ist die Auslenkung von freistehenden piezoelektrischen Strukturen durch elektrostatische Felder. Dabei liegt im Prinzip ein piezoelektrisches Material zwischen zwei Metallplatten. Durch den inversen piezoelektrischen Effekt kommt es zu Verformung und Deformierung des piezoelektrischen Materials, wenn an die Elektroden eine elektrische Spannung angelegt wird.

Durch dem Fachmann bekannte Prozesse (Epitaxie auf einem Wafer bzw. Trägersubstrat, bevorzugt aus Si) wird ein freistehender Balken mit einer Schicht 2u und einer darauf angeordneten Schicht 2o aus einem piezoelektrischen Material hergestellt. Bei der Prozessierung des Balkens werden die zwei Elektroden 3a und 3b hergestellt. Dabei wird der Kontakt, der das 2DEG kontaktiert, bevorzugt durch Legierung hergestellt, so dass eine leitende Verbindung der Metallelektrode zum 2DEG aufgebaut wird. Durch das Anlegen einer elektrischen Spannung verformt sich die piezoelektrische Schicht 2o und der Balken wird ausgelenkt.

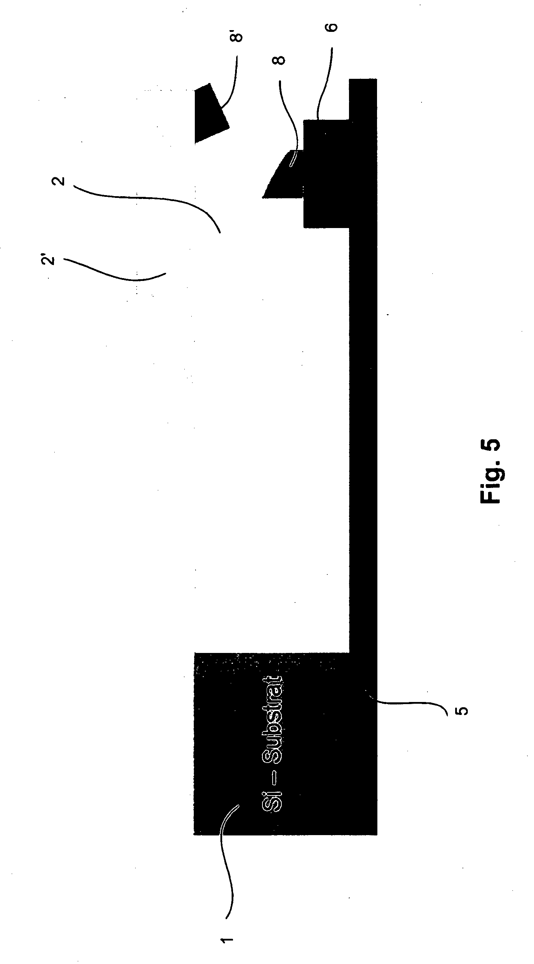

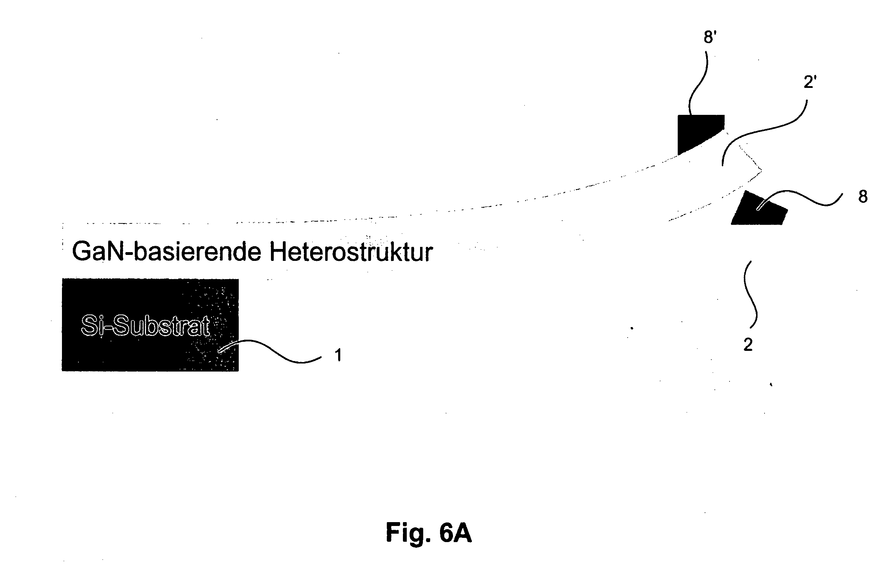

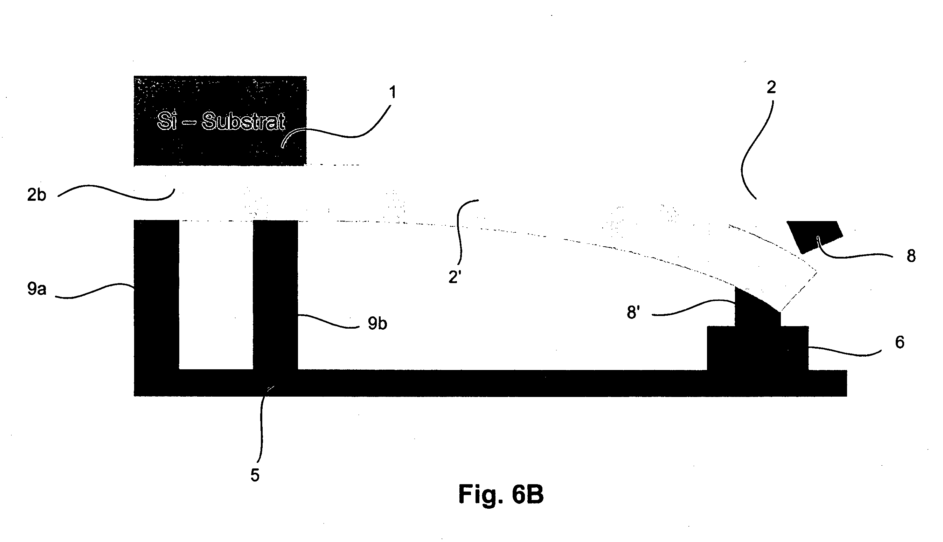

Die gezeigten Ga/Al/In-Nitrid-basierenden Heterostrukturen, in denen starke piezoelektrische Felder auftreten, erlauben es somit, freistehende Balken oder Aktoren zu realisieren, bei denen die piezoelektrische Komponente bereits integriert ist. Ausgehend von einer ggf. bereits vorverspannten (siehe Fig. 5 und 6) Ga/Al/In-Nitrid-basierenden Heterostruktur auf einem Silizium-Substrat wird analog zur elektrothermischen Variante der Fig. 1 ein freistehender Balken mit einem Kontaktstempel strukturiert. In der Regel besteht die Heterostruktur aus einem AlGaN/GaN-Schichtsystem. Um aber eine möglichst große piezoelektrische Verspannung zu erzielen, sind auch reine AlN/GaN-Schichten denkbar oder auch der Einsatz von InGaN- oder InAlN-Schichten in einer Heterostruktur ist denkbar.

Hier wird der piezoelektrische aktive Layer 2o zwischen zwei Elektroden eingespannt. Dabei verursacht die obere Metall-Elektrode bei der Herstellung kein Problem. Allerdings ist es nicht möglich aufgrund des epitaktischen Wachstums dieser Schichtfolge eine externe Elektrode in diesem Materialsystem am Ort der Elektrode 3b zu platzieren. Daher wird erfindungsgemäß die hohe Ladungsträgerdichte (2DEG) an der Heterostruktur-Grenzfläche selbst als Elektrode 3b genutzt.

Wesentlicher Aspekt ist hier somit, dass keine zusätzliche dotierte Schicht und/oder Metallschicht oder ähnliches in die Struktur 2 eingebracht werden muss, um als Elektrode 3b zu dienen. Es ist eine direkte Kontaktierung (im stirnseitigen Bereich S) mit einem herkömmlichen metallenen Kontakt möglich, ohne dass es hier zusätzlicher, elektrisch leitfähiger Strukturen bedarf. Auf einfache Art und Weise ist somit die Herstellung der vorbeschriebenen Struktur und die Anlegung einer Spannung 7b an die piezoelektrische Schicht 2o möglich. Wie bei der in Figur 1 gezeigten Variante ist der gesteuerte Strom (Nutzsignal), welcher über den Kontaktschluss der Elemente 8 und 6 fließt, vom Steuersignal 7a bzw. 7b völlig getrennt.

Ein weiterer wesentlicher Aspekt dieser Variante ist die bevorzugte Verwendung eines 111-Siliziumsubstrates. Jedoch kann auch ein 100-Siliziumsubstrat oder ein 110-Siliziumsubstrat zum Einsatz kommen. Bei geeigneter Anpassung der Prozess-oder Epitaxietechnologie kann auch ein anderes Substrat als das beispielhaft in Fig. 3 verwendete Silizium - wie etwa Saphir oder Siliziumkarbid - verwendet werden.

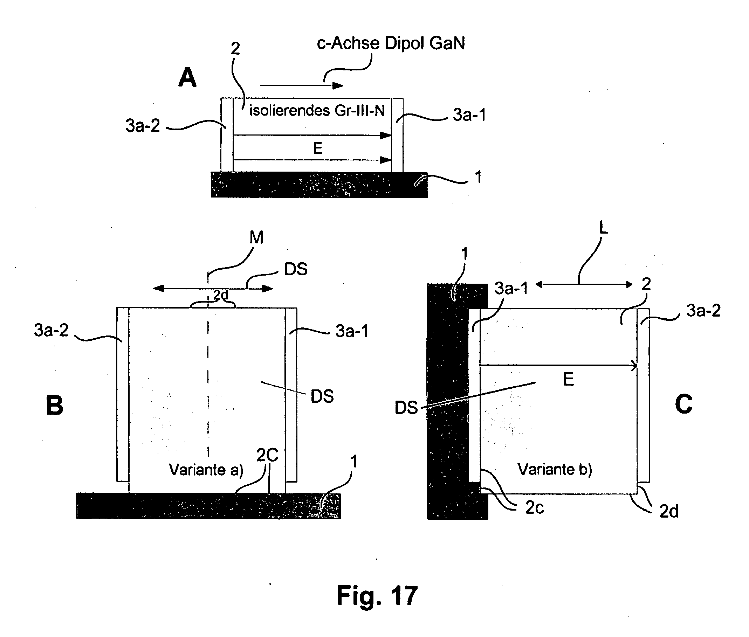

Die Funktionsweise dieser Variante wird nachfolgend beschrieben. Hierzu wird zunächst der Begriff der spontanen Polarisation (nachfolgend auch als Psp bezeichnet) definiert. Hierunter wird die Polarisation eines unverspannten Kristalls aufgrund der Gitterstruktur (beispielsweise der hexagonalen Gitterstruktur) verstanden. Unter piezoelektrischer Polarisation (nachfolgend auch als Ppz bezeichnet) wird die spannungsinduzierte Polarisation verstanden: Bei Wachstum eines Kristalls auf einem Fremdsubstrat passen die Gitterkonstanten nicht zusammen, so dass die Epitaxieschicht (so lange sie wesentlich dünner ist als das zugrunde liegende Substrat) verspannt wird. Bei normalerweise verwendetem 111-Silizium steht nun die c-Achse der Halbleiterverbindungen auf Basis von Nitriden von Hauptgruppe-III-Elementen senkrecht zur Oberfläche, also senkrecht auf der Trennfläche zwischen dem Substrat und einer aufgewachsenen Halbleiterstruktur. Beispielsweise steht der Dipol einer GaN-Schicht normalerweise (beispielsweise bei Herstellung mittels metallorganischer Gasphasenepitaxie, engl. metal organic chemical vapour phase epitaxy, MOCVD) so, dass die Ga-Seite oben ist, d.h. auf der Substrat-abgewandten Seite angeordnet ist (sog. "Ga-face": auf der dem Substrat zugewandten Seite beginnt die N-Lage, der Abschluss der aufgewachsenen Halbleiterstruktur an der Oberfläche des Halbleiters, also auf der Substrat-abgewandten Seite ergibt sich als Ga-Lage, der Vektor der Psp steht senkrecht zum Substrat und zeigt zum Substrat hin). Dies gilt ebenso für Ppz. Es ist nun jedoch auch möglich (beispielsweise mittels Molekularstrahlepitaxie) durch veränderten Wachstumsstart die Richtung des Dipols umzudrehen (sog. "N-face": Hier erhält man auf der dem Substrat zugewandten Seite die Ga-Lage, der obere Abschluss ergibt sich dann mit der N-Lage). Es steht dann der Vektor der Psp immer noch senkrecht zum Substrat bzw. zu der Grenzfläche zwischen Substrat und aufgewachsener Halbleiterstruktur, die Richtung ist jedoch weg vom Substrat gerichtet, (ebenso im Falle Ppz). Für den typischen Fall einer elektrostatischen Auslenkung des Aktors senkrecht zum Substrat wird der Aufbau so gewählt, dass die c-Achse des Kristalls senkrecht zum Substrat steht (Beispiel: AlGaN/GaN-Struktur auf einem 111-Siliziumsubstrat). Für eine elektrostatische Auslenkung des Aktors in der Substratebene muss der Aufbau jedoch modifiziert werden: Ziel ist nun, die c-Achse um 90° zu kippen, also in eine Richtung parallel zur Trennebene zwischen dem Substrat und der aufgewachsenen Halbleiterstruktur zu bringen (vgl. auch Figur 17A nachfolgend). Hierzu muss das Wachstum des Kristalls verändert werden. Beispielsweise kann auf einem 100-Si-Substrat so gewachsen werden, dass sich, wie vorstehend beschrieben, ein hexagonales Gitter mit Ga-Face ausbildet. Es kann aber auch so gewachsen werden, dass der Kristall ein kubisches Gitter aufweist, wobei hier Psp 0 wird (Ppz nicht). Es kann somit eine Epitaxie auf höher indizierten Wachstumsebenen (also auf verkippten Wachstumsebenen) erfolgen, welche für eine reduzierte Polarisation sorgen (sog. Semipolare Facetten). Es kann somit erfindungsgemäß auch ein Substrat mit anderer Orientierung (etwa 100- oder 110- anstelle von 111-Si) verwendet werden, alternativ dazu kann jedoch auch ein strukturiertes Substrat verwendet werden (letzteres beispielsweise durch Ätzen oder Deposition von Schichten, so dass an bestimmten Stellen Gräben oder Hügel mit schrägen Seitenflanken entstehen). Dies erfolgt, um die Piezopolarisation zu beeinflussen.

Wird nun zwischen der Kanalladung 2DEG an der Heterostruktur-Grenzfläche und der oberen Elektrode 3a eine Spannung 7b angelegt kommt es aufgrund des inversen piezoelektrischen Effektes zur Verspannung der Ga/Al/In-Nitrid-basierenden Heterostruktur. Der Balken wird ausgelenkt und kann die schon in Fig. 1 beschriebene Schalterfunktion erfüllen.

Auch hier liegt ein entscheidender Vorteil der piezoelektrischen Ga/Al/In-Nitrid-basierten Aktuatoren in der Einfachheit des Aufbaus. Mit der Grundlage einer Ga/Al/In-Nitrid-basierenden Heterostruktur auf Silizium - Substrat sind alle Komponenten, die zur Realisierung eines piezoelektrischen Aktors notwendig sind, bereits in der Schichtstruktur implementiert. Die hohen piezoelektrischen Felder und die großen Ladungsträgerdichten in der Ga/Al/In-Nitrid-basierten Heterostruktur erlauben eine einfache Herstellung eines piezoelektrischen Aktors.

Das Schaltverhalten der piezoelektrischen Ga/Al/In-Nitrid-basierenden Schalter ist abhängig von den piezoelektrischen Konstanten, dem Elastizitätsmodul, der Balkengeometrie und der angelegten Spannung.

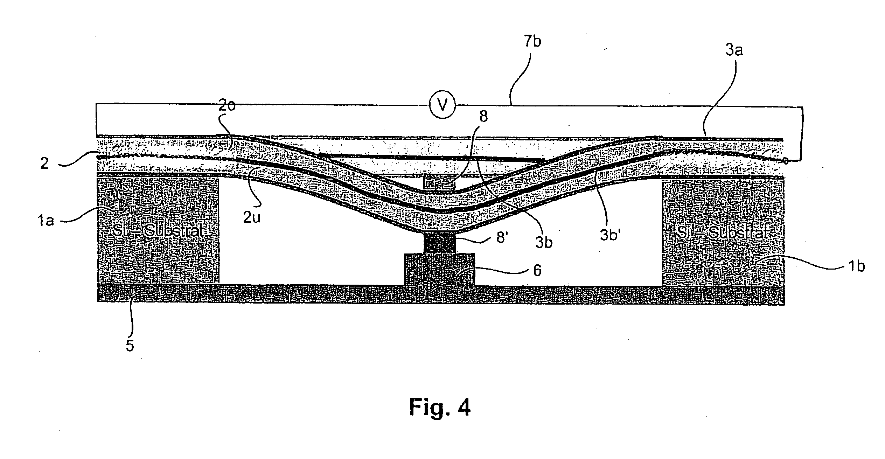

Figur 4 zeigt eine weitere Variante der Erfindung in Form eines elektrostatisch auslenkbaren Schalters in Form eines doppelt eingespannten freistehenden Balkens einer AlGaN/GaN-Heterostruktur wie in Fig. 3. Der Aufbau der in Figur 4 gezeigten Variante ähnelt dem grundlegenden Aufbau der Figur 2 und weist die folgenden Unterschiede auf (die weiteren Aspekte ergeben sich wie im in Figur 2 gezeigten Fall): Anstelle der insgesamt vier an der Oberfläche der Balkenstruktur angeordneten Zuleitungskontakte 3a1, 3b1, 3a2 und 3b2 des in Figur 2 gezeigten Falls weist die doppelseitig eingespannte Balkenstruktur wie in Fig. 3 gezeigt zwei Elektroden 3a (Oberseite der Balkenstruktur, teil- oder vollflächige Metallelektrode) und 3b (wie in Fig. 3 als 2DEG-Elektrode ausgebildet) auf. Die Funktionsweise bei Anlegung einer Spannung 7b zwischen den beiden Elektroden 3a und 3b mit dazwischen sandwichförmig eingelegter Halbleiterschicht 2o aus AlGaN ergibt sich daher wie beim in Figur 3 gezeigten Fall. Bei der gezeigten Heterostruktur werden somit als Elektroden eine Metallschicht an der Oberfläche (Elektrode 3a) und das 2DEG (Elektrode 3b) der Heterostruktur verwendet. Beim Anlegen der Spannung verändert sich durch den umgekehrten Piezoeffekt die Gitterkonstante senkrecht und horizontal zum Balken, so dass eine Längenänderung im oberen Balkenabschnitt 2o resultiert. Da der untere Bereich 2o nicht verändert wird, ergibt sich eine Verbiegung der gesamten Struktur 2.

Eine solche Funktionsweise kann auch im Fall einer homogenen Halbleiterstruktur nachgebildet werden, indem nicht-erfindungsgemäß eine dotierte Schicht anstelle des 2DEG eingeführt wird: Eine solche Variante, welche hier nicht gezeigt ist, und welche ebenfalls als einseitig oder zweiseitig eingespannter Balken realisiert werden kann, ergibt sich, wenn auf einer unteren (der Platine zugewandten) ersten GaN-Schicht durch Dotierung mit Silizium eine Zwischenschicht erzeugt wird, auf die dann weiter eine zweite GaN-Schicht als Oberseite der Balkenstruktur epitaktisch aufgewachsen wird. Die siliziumdotierte Zwischenschicht kann dann (z.B. bei stirnseitiger Kontaktierung im Bereich S) als zweiter elektrischer Zuleitungskontakt 3b verwendet werden, eine auf der Oberseite der zweiten GaN-Schicht aufgebrachte teil- oder vollflächige Metallisierung dann als erster elektrischer Zuleitungskontakt.

Es gibt hierbei zwei Möglichkeiten, diese leitfähige dotierte Schicht (beispielsweise die genannte siliziumdotierte Zwischenschicht) zu erzeugen: Entweder direkt während der Epitaxie (Wachstum des unteren Bereichs 2u, Wachstum der dotierten Schicht, welche dann als Elektrode 3b verwendet wird, dann Wachstum des oberen Bereichs 2o) oder Wachstum einer undotierten homogenen Schicht und Implantation einer Dotierung in der gewünschten Tiefe. Der Vorteil bei der ersten Realisierung ist, dass Implantationsprozessschritte entfallen, aber durch Verschleppung der Dotieratome beim Wachstum der oberen Schicht kann es zu unscharfen Dotierprofilen kommen, wodurch sich unerwünschte Restleitfähigkeiten in der oberen Schicht ergeben. Bei der letztgenannten Variante kann bei Implantation die gesamte homogene Schicht auf eine hohe Isolation "getrimmt" werden (Es ergibt sich eine sehr saubere Wachstumsanlage ohne Dotierstoffe) und es kann gezielt ein Bereich nachträglich leitfähig gemacht werden.

Figur 5 zeigt nun nicht die Erfindung, aber eine weitere Variante einer freistehenden Balkenstruktur, welche grundsätzlich wie die in Figur 1 gezeigte Variante ausgebildet ist, jedoch die folgenden Unterschiede aufweist: Bei allen bisher gezeigten Varianten ist der OFF-Zustand des Schalters (Elemente 6 und 8 nicht elektrisch leitend verbunden) durch die Ruhelage des Balkens, also diejenige Lage, in der kein Strom eingeprägt bzw. keine Spannung angelegt ist, eingestellt. Erst durch den Einfluss von elektrischen Größen werden die in Figuren 1 bis 4 gezeigten Schalter in den ON-Zustand gebracht.

Im Ga/Al/In-Nitrid-basierenden Materialsystem ist das Verhalten bzw. die Position des freistehenden Balkens in Ruhelage abhängig von der Verspannung der epitaktisch aufgewachsenen Schicht 2. Je nachdem, ob die Schicht(en) zug- oder druckverspannt sind oder etwa mit Hilfe von Stresskompensationsschichten nahezu unverspannt sind, kann sich die Ruhelage des freistehenden Balkens ändern. So ist es durchaus möglich, dass je nach Wachstumsbedingungen die Ruhelage des Balkens auch den ON-Zustand repräsentieren kann. Das heißt, dass der Balken in seiner Ruhelage 2 bereits ausgelenkt ist. Erst durch das Anlegen elektrischer Größen wird dann vom ON-Zustand in den OFF-Zustand geschaltet und der Balken geht in eine waagrechte Position 2' über. Daraus ergibt sich die Möglichkeit je nach Einsatzgebiet die energetisch günstigste Variante der Ga/Al/In-Nitrid-basierenden Schalter zu wählen. Somit kann der Wirkungsgrad des Gesamtsystems weiter erhöht werden.

Weiterhin ist es (siehe Figuren 6A und 6B, die nicht die Erfindung zeigen, aber Aspekte davon) auch möglich, aufgrund der Verspannungsmomente in Ga/Al/In-Nitrid-basierten Materialsystem Balken 2 zu realisieren, die sich beim Anlegen des Stroms bzw. der Spannung nach oben auslenken. Nach oben meint hier, dass sich das freistehende Ende in Richtung senkrecht zur Platinenebene gesehen vom Substrat 1 weg bewegt. Wie auch in Figur 5 sind in den Figuren 6A und 6B zur Vereinfachung die elektrischen Kontakte 3 nicht mehr eingezeichnet. Wie Figur 6A zeigt, befindet sich der Balken 2 in der Ruhelage in waagrechter Position. Durch geeignet gewählte Vorspannung der Halbleitermaterialien bzw. der Schichten erfolgt bei Anlegen der elektrischen Größen eine Verbiegung des Balkens nach oben, also hier in die vom Siliziumsubstrat 1 wegweisende Richtung (Position 2'). Damit ein entsprechender Kontaktschluss möglich ist, ist aus diesem Grund das Kontaktelement 8, 8' auf der der Substratbasis 1 abgewandten Oberseite der Balkenstruktur 2 aufgebracht. Figur 6B zeigt einen weiteren solchen Fall: Durch die geeignet gewählte Vorspannung ist hier eine vereinfachte Aufbautechnik möglich: Siliziumsubstrat 1 und Biegestruktur 2 werden hier in umgekehrter Reihenfolge in Bezug auf die Platine 5 gesehen, angeordnet. Zwischen der (in Bezug auf das Substrat 1 gesehen) Oberseite der Balkenstruktur 2 und der Platine 5 sind zwei Bumps 9a und 9b zur Einstellung eines geeigneten Abstands zwischen Balkenstruktur 2 und Platine 5 angeordnet (im Bereich 2b). In der Ruhelagen befindet sich der Balken in waagrechter Position 2; auf seiner Oberseite ist wie in Figur 6A der Kontaktstempel 8 aufgebracht. Bei Anlegung der elektrischen Größe erfolgt eine Auslenkung (bezüglich des Substrats 1 gesehen) nach oben, wodurch sich der Abstand des freien Balkenendes zur Platine 5 verringert und mittels des Kontaktstempels 8 der Kontakt zum Wellenleiter 6 geschlossen wird (Position 8'). Die Bumps 9 werden mit Hilfe galvanischer Verfahren auf der Oberseite der Platine oder auch auf der Halbleiterstruktur erzeugt; mit ihrer Hilfe kann somit die Struktur aus Balken 2 und Substrat 1 kopfüber auf ein entsprechendes Board bzw. die Platine gebondet werden.

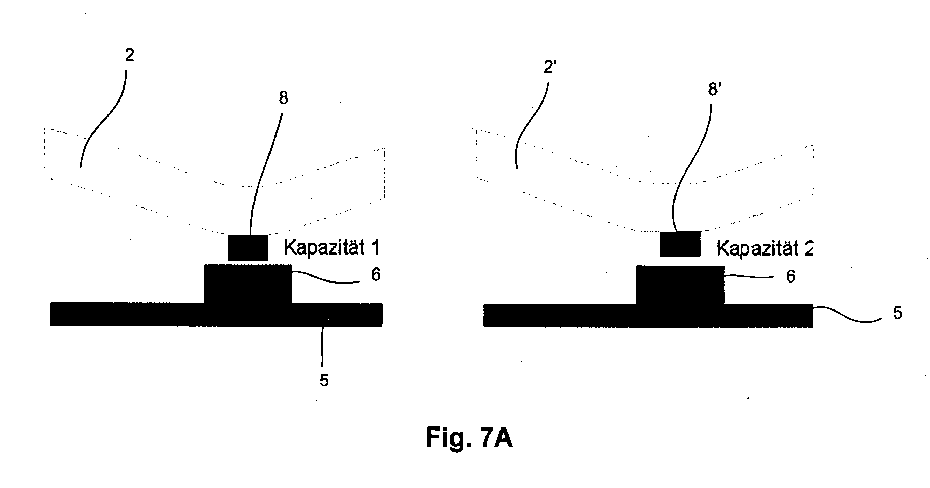

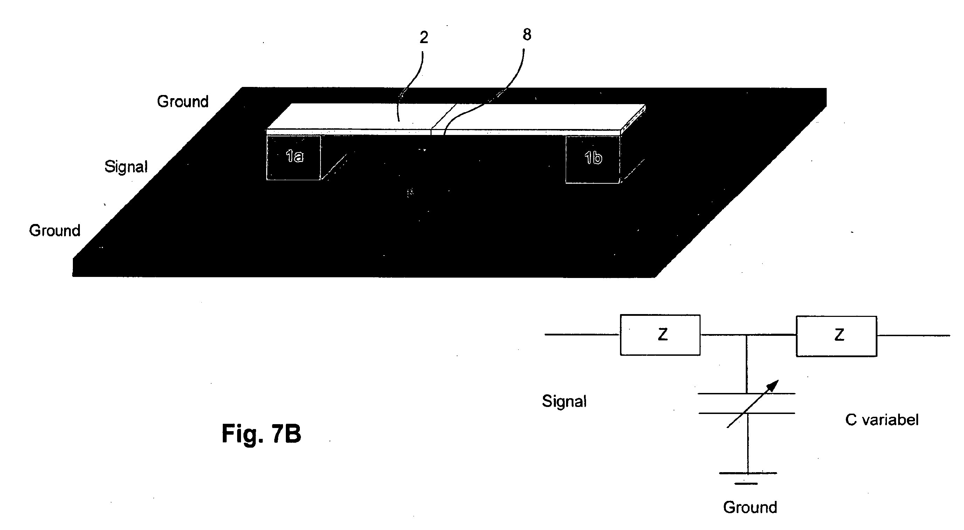

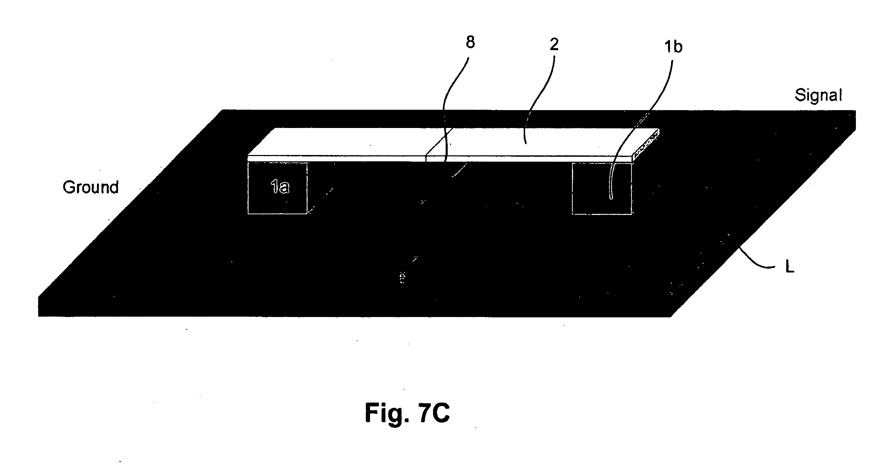

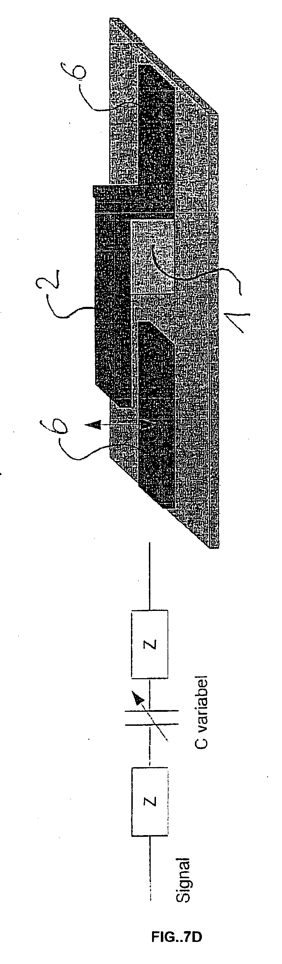

Figur 7 zeigt nicht die Erfindung, aber wie mit Hilfe erfindungsgemäßer Halbleiteraktoren Varaktoren (veränderbare Kapazitäten) anstelle von Schaltkontakten realisiert werden können. Der grundsätzliche Aufbau entspricht hierbei dem Aufbau der Schalter, wie sie in Figuren 1 bis 6 gezeigt sind. Bei der Realisierung erfindungsgemäßer Varaktoren erfolgt die Änderung der Kapazität des Bauelements durch die Variation des Abstands zweier Metallelemente (im Beispiel: Stempel 8 und Wellenleiter bzw. Gegenelement 6) zueinander. Figur 7a zeigt hierbei das Prinzip in einer Skizze in einem Aufbau mit doppelseitig eingespanntem Balken (gezeigt sind hier nur die wesentlichen Elemente). Im linken Bild gezeigt ist eine größere Auslenkung des doppelseitig eingespannten Balkens (Position 2) als im rechts dargestellten Fall (Position 2'). Der Abstand (senkrecht gesehen zur Platinenebene 5) des Elements 8 von dem Gegenelement 6 ist somit im links gezeigten Fall geringer als im rechts gezeigten Fall (dort Position 8'). Aufgrund der bereits vorbeschriebenen Linearität führt die rechts gezeigte Auslenkung (welche der Hälfte der Vollauslenkung entspricht) zum halben Kapazitätswert wie im links gezeigten Fall.

Der technologische Aufbau der Ga/Al/In-Nitrid-basierten Varaktoren ist äquivalent zu denen eines MEMS Schalters. Allerdings sind bei der Varaktorausführung nicht nur zwei Betriebszustände realisierbar (ON, OFF), sondern auch alle Zwischenstufen. Der Balken kann seine Position bzw. Auslenkung dabei variabel verändern, je nachdem welcher eingeprägte Strom oder angelegte Spannung vorliegt. Je genauer die Position bzw. Lage des Balkens einstellbar ist, desto präziser ist auch die Einstellmöglichkeit der Kapazität und somit beispielsweise eine Variabilität eines Anpassnetzwerkes einer Hochfrequenz-Basisstation, in welchem die einzelnen Anpassschaltblöcke mittels solcher Varaktoren angesteuert werden können. Sowohl die Ausführungsform der Ga/Al/In-Nitrid-basierenden Schalter als elektrothermischer Variante also auch die piezoelektrische Variante eignen sich zur Realisierung von Varaktoren, da in beiden Fällen nicht nur eine diskrete Schaltung zwischen zwei Zuständen, sondern eine variable Steuerung des Auslenkung durch die äußeren elektrischen Größen möglich ist.

Je nachdem, in welchem Signalpfad die Varaktoren eingesetzt werden unterscheiden sie sich in ihrem Aufbau. Variable Kondensatoren in einem Anpassnetzwerk können sowohl parallel zur Signalleitung (Shunt C) als auch in Serie dazu geschaltet werden. Abhängig vom Einsatz des Varaktors im Anpassnetzwerk sind differenzierte Eigenschaften bezüglich Isolationsverhalten und Eigenverluste möglich. In einer Serienschaltung (Fig. 7B) führt der Signalpfad über das Ga/Al/In-Nitrid-basierende Varaktor-Bauelement. Das bedeutet, dass der Varaktor möglichst geringe Eigenverluste aufweisen muss, um keine Dämpfung des Signals zu verursachen. Bei einer Parallelschaltung (Fig. 7C) ist eine hohe Isolation des Varaktors notwendig, um keine parasitären Verluste zu erzeugen.

Im in Figur 7C gezeigten Fall der Parallelschaltung des Varaktors führt der Signalpfad somit nicht über das Ga/Al/In-Nitrid-basierte Varaktorbauelement, sondern über die Leitung L auf der Platine.

Die (dem Gegenelement 6 entsprechenden) Leitungsabschnitte 6 auf der Oberfläche der Platine 5 sind in den in Figur 7B und 7C gezeigten Strukturen bereits geschlossen, da hier der Kontaktstempel 8 keinen direkten Kontakt mit den Elementen 6 erfährt (wie beim vorstehend beschriebenen Schalter), sondern nur seinen Abstand über den Elementen 6 verändert. Im in Figur 7B gezeigten Fall ergibt sich die Kapazität C der gezeigten Anordnung aus dem Kondensator, der zwischen Signal und Ground durch das Element 8 (welches über den Balken 2 an den mit Signal "bezeichneten" Leitungsteilen angeschlossen wird und eine Fläche A aufweist) und das Element 6 (Anschluss an Ground) gebildet wird:

$$C = \varepsilon_0 \cdot \varepsilon_r \cdot A/d,$$

wobei d der Abstand von den Elementen 8 und 6 ist. Daher wird die Kapazität der Leitung zur Masse mit dem Abstand d variiert. Die in Figur 7B links oben gezeigte Variante (Ausführung in Coplanar-Technologie) entspricht damit in erster Näherung dem in Figur 7B rechts unten gezeigten Ersatzschaltbild (Z ist der Wellenwiderstand der Leitung).

Figur 7D zeigt eine weitere Variante, bei welcher ein Varaktor mit variabler Kapazität in Serie erzeugt wird (Ersatzschaltbild Figur 7D links, prinzipieller Aufbau rechts; die Kontakte 3 zur Balkenauslenkung sind hier nicht gezeigt). Die wieder als einseitig eingespannter, freistehender Balken realisierte Variante von Figur 7D kann in einer Schaltkonfiguration gemäß Figur 7B ebenso wie in einer Schaltkonfiguration gemäß Figur 7C Anwendung finden. Die in den Figuren 7B und 7C gezeigten Schaltkonfigurationen lassen sich somit in zwei Ausführungen realisieren (mit der Kapazität C parallel zur Masse oder in Serie). Grund-sätzlich weist die in Figur 7B gezeigte Variante den Nachteil auf, dass das Nutzsignal über den Balken geführt werden muss (in der vereinfachten skizzenartigen Darstellung sind die Leiterstrukturen, welche für das Nutzsignal verwendet werden, nicht alle eingezeichnet). Dies gilt im in Figur 7B gezeigten Fall ebenso, wie bei der gemäß Figur 7D realisierten Variante mit dem einseitig eingespannten Balken. Dies ist bei der in Figur 7C gezeigten Variante (bei beiden Methoden der Kapazitätsrealisierung, also mit der Kapazität parallel zur Masse oder in Serie) nicht erforderlich.

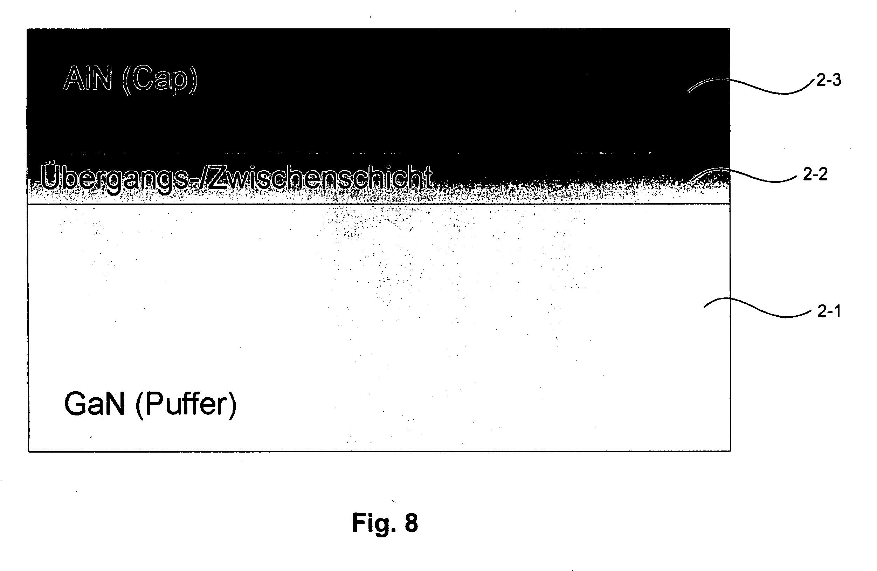

Figur 8 zeigt nicht die Erfindung, aber in Seitenansicht eine Halbleiterstruktur, wie sie besonders bevorzugt für die in Figur 1 und Figur 2 gezeigten Varianten des Aktors eingesetzt werden können. Die Biegestruktur 2 weist an ihrer dem Substrat 1 zugewandten Seite eine untere Schicht 2-1 aus GaN (Pufferschicht) auf. Auf dieser ist eine Übergangs- oder Zwischenschicht 2-2 angeordnet, auf welcher wiederum eine Deckschicht (obere Schicht, welche die elektrischen Zuleitungskontakte 3a und 3b trägt) aus AlN angeordnet (Schicht 2-3). Diese Variante aus einem Mehrschichtsystem mit mindestens zwei Materialien (Pufferschicht und Deckschicht) hat bei Wahl wie im vorgestellten Fall der beiden Materialien mit möglichst unterschiedlichem thermischem Ausdehnungskoeffizient den Vorteil, dass der Wärmetransport entlang der Balkenlängsrichtung deutlich größer ist als der Wärmetransport senkrecht dazu in Querrichtung im Balken. Die gezeigte Variante optimiert die unterschiedlich starke thermische Ausdehnung der oberen und der unteren Schicht des Balkens. Vorteilhafterweise ist hierbei mindestens eine der Schichten leitfähig ausgestaltet (z.B. durch entsprechende Dotierung) so dass sie sich bei Stromdurchfluss (eingeprägt über die elektrischen Zuleitungskontakte 3a, 3b) erwärmt. Eine solche Erwärmung und damit Ausdehnung ist grundsätzlich auch ohne elektrische Zuleitungskontakte über eine externe Heizung möglich (etwa im Ofen, so dass sich ein thermischer Schalter realisieren lässt, der ähnlich wie ein klassischer Dehnungsstreifen arbeitet). Wie beim in den Figuren 3 und 4 gezeigten Fall dehnt sich hier somit eine der Schichten stärker aus als die andere.

Als Pufferschicht ist hierbei alles geeignet, auf dem monokristallin Gallium-III-Nitride hexagonal abgeschieden werden können. (Hierbei ist zu beachten, dass die untere GaN-Schicht in der Regel stets aus mehreren Schichten besteht, da ein einkristallines Wachstum direkt auf dem Substrat wegen der Gitterfehlanpassung nur schwerlich möglich ist. Daher werden Anwachsschichten für die entsprechenden Halbleiterstrukturen verwendet, die eine Vermittlung zwischen einkristalliner Pufferschicht und Substrat 1 ermöglichen. Dies sind meist polykristalline AlGaN-und/oder AlN-Schichten, die zudem der Stresskompensation dienen. Nach mehreren solcher Lagen wird ein Quasi-Substrat dargestellt durch eine erste Lage GaN, die einkristallin ist. Die direkt darauf befindliche Schicht aus GaN wird im eigentlichen Sinn als Pufferschicht bezeichnet, da diese elektrisch zum Bauelement gehört und so dick sein muss, dass die Anwachsschichten möglichst keinen Einfluss mehr auf die Bauelemente haben. Im Falle der erfindungsgemäß realisierten mechanischen Balken bringen solche Anwachsschichten in der Regel nach dem Freilegen vom Substrat 1 mechanischen Stress in die Schicht 2. Hieraus resultiert auch die bereits beschriebene Verbiegung im Ruhezustand. Man kann dabei diese Schichten reduzieren oder auch nachträglich wegätzen.)

Die auf die Schicht 2-3 aufzubringenden elektrischen Zuleitungskontakte 3a, 3b sind dabei überall auf der Oberfläche der Schicht 2-3 denkbar; Voraussetzung ist lediglich eine flächige Wärmeeintragung in den Balken 2 beim Betrieb mit Strom bzw. beim Anlegen einer Spannung. Bei der Ausbildung als MESFET-Typ (vgl. die in Figuren 1 und 2 gezeigten Varianten) also mittels partiell dotiertem oder undotiertem Gruppe-III-Nitrid ist hierbei eine etwas geringere Auslenkung zu erwarten im Vergleich zu einem als Heterostruktur mit AlGaN-Cap (mit 2D-Elektronengas) ausgestalteten Balken. Eine Variation der Dotierung im hier bzw. im in den Figuren 1 und 2 gezeigten Fall bietet jedoch eine Möglichkeit, die Einstellung der Aktuationsspannung (d.h. derjenigen Spannung, welche für maximale Auslenkung notwendig ist) in einem größeren Bereich zu variieren. Dies ist bei einer AlGaN/GaN-Heterostruktur lediglich in etwas geringerem Maße möglich, da die maximale Dicke des AlGaN technisch limitiert ist.

Bei der Verbindung der elektrischen Zuleitungskontakte 3 mit den entsprechenden Abschnitten auf der Biegestruktur 2 ist der Einsatz konventioneller Löttechnik möglich. Ebenso ist der Einsatz sog. "Face-to-Face"- oder "Back-to-Face"-Techniken mit Durchkontaktierungen (Wires) möglich. Unter einem Back-to-Face-Bauelement wird ein Bauelement bzw. Balken verstanden, welcher auf eine Weise vereinzelt wird, dass sich die Metallisierung für den Kontaktstempel oder die variable Kapazität auf der Balkenunterseite (Substrat-zugewandte Seite, "back") befindet. Das Bauelement wird dann auf die Schaltungsseite der Platine ("face") verlötet. Unter einem Face-to-Face-Bauelement wird ein Bauelement bzw. Balken verstanden, der wie gerade beim Back-to-Face-Bauelement beschrieben, realisiert wird, jedoch befindet sich die Metallisierung auf der Oberseite des Balkens ("face"). Beim Löten muss daher der Chip mit dem Aktor umgedreht montiert werden. Der Abstand Balken-Signalleitung der Platine kann dann über Lötbumps, die auf die Oberseite des GaN-Balkens oder die Platine aufgebracht werden, einfacher eingestellt werden (hier muss dann die Dicke des Substrates 1, welche üblicherweise zwischen 100 und 1000 μm liegt, überbrückt werden, da die Balken typischerweise nur um 0.5 bis etwa 5 μm auslenken; bei der Face-to-Face-Variante können die Lötbumps in der gewünschten Dicke aufgebracht werden, welche etwa der Auslenkung entspricht).

Der Aufbau ist hierbei direkt auf hochfrequenztauglichen Substratbasen möglich, welche mit Lötmetallisierungen versehen sein können. Das Basissubstrat muss hierbei keine aktiven oder passiven Bauteile besitzen (außer Leitungen), kann dies aber. Dies gilt ebenso für die Aktoren, die integrierte aktive oder passive Bauelemente auf Basis von Gruppe-III-Nitriden bzw. auch ganze integrierte Schaltungen (etwa zur Ansteuerung des Aktors) aufweisen können. Erfindungsgemäß ist eine Verkapselung der erfindungsgemäßen Schalter und/oder Varaktoren möglich; die hierbei entstehenden, luftdichten Kammern können mit Vakuum oder mit verschiedenen Gasen (vornehmlich Inertgasen) gefüllt sein. Mit den beschriebenen Prozessen sind auch Mehrfachlötungen sowie Stapelungen möglich.

Erfindungsgemäß kann die Justage der erfindungsgemäßen Varaktoren und/oder Schalter wie folgt realisiert werden. Die Messung der Kapazität ist an fertig prozessierten Bauelementen und mittels der Einstellung einer bestimmten Auslenkungsspannung für die gewünschte Kapazität möglich. Andere Bauelemente können auf die gleiche Auslenkungsspannung vorjustiert werden. Dies kann auch mit einer speziellen Kalibrationsstruktur, welche wie ein erfindungsgemäßer Varaktor und/oder Schalter aufgebaut ist, und die bei jedem aufzubauenden komplexeren Bauelement auf der Platine integriert werden kann, erfolgen. Mittels eines solchen Vorgehens ist eine hoch genaue elektrische Justage möglich. Dies ist jedoch nur erforderlich, wenn ganz bestimmte Werte der Kapazität eingestellt werden müssen (etwa bei einer Anpassungsschaltung von Hochfrequenztransistoren kann solange interaktiv die anzulegende Spannung verändert werden, bis ein gewünschter Effekt eintritt, etwa die höchste Ausgangsleistung oder die beste Effektivität). Eine mechanische Justage ist wie nachfolgend noch näher beschrieben durch Ätzung des Balkens und damit auch durch die Einstellung einer ggf. notwendigen Ruhelagen-Krümmung möglich.

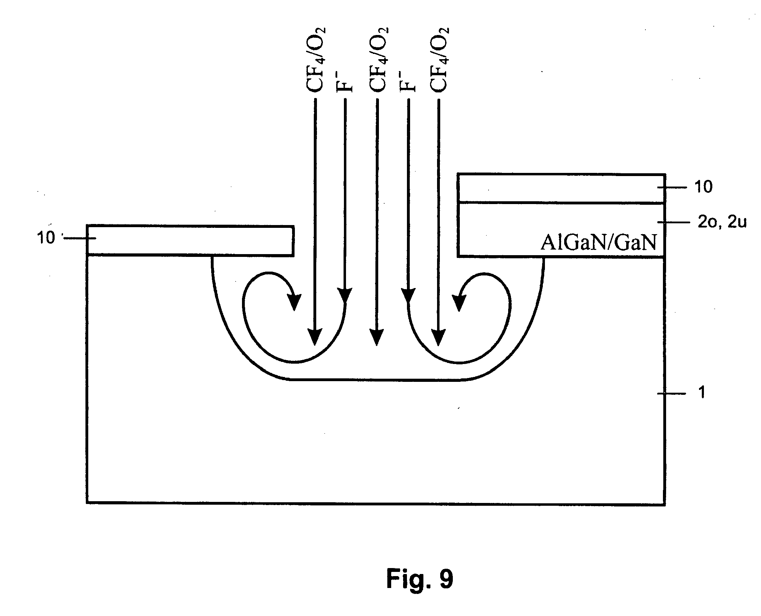

Das nachstehend an Figur 9 beschriebene Verfahren zum Ätzen des Siliziumsubstrates, um die Biegestrukturen 2 freizulegen ist nur eine Möglichkeit: Typischerweise wird ein Trockenätzverfahren von der Rückseite her (etwa "ICP-Bosch-Prozess" oder Cryo-ICP-Ätzung oder ähnliches) verwendet. Beim 100-Silizium ist auch eine chemische Ätzung (etwa mit KOH) möglich; bei Herstellung der Aktoren auf anderen Substraten wie etwa Saphir oder Siliziumkarbid, etwa mit Hilfe von sog. Opferschichten (etwa auf einem Substrat vor der Epitaxie der Gruppe-III-Nitride strukturiert aufgebrachtem Siliziumnitrid oder -oxid), so dass die Gruppe-III-Nitrid-Schichten nur teilweise direkt auf dem Substrat aufwachsen und sich teilweise über diesen Opferschichten befinden, ist auch ein Freilegen der Balkenstrukturen durch Entfernen bzw. Ätzen dieser Opferschichten möglich.

Figur 9 zeigt einen wesentlichen Schritt, das Unterätzen der Balkenstruktur 2, bei der Herstellung eines erfindungsgemäßen Heterostruktur-Aktorelements schematisch. Anhand von Figur 9 seien zunächst auch die anderen Schritte des Halbleiterstrukturierungsverfahrens zur Herstellung eines erfindungsgemäßen Aktorelements erläutert. Zunächst wird aus dem Verbund aus AlGaN Deckschicht 2o und GaN-Basisschicht 2u (hier beispielsweise Deckschicht aus $Al_{0.2}Ga_{0.8}N$) eine Mesa einer gewünschten Grundfläche ausgeätzt, indem die Heterostruktur 2 außerhalb der Grundfläche bis auf die Substratbasis 1 weggeätzt wird. Die zurückbleibende Mesa ist in Figur 5 rechts oben gezeigt (Abschnitt 2o, 2u). Die zu unterätzenden Bereiche (Mesabereich 2o, 2u rechts im Bild sowie Substratbereich links im Bild) werden durch Aluminiummaske 10 abgedeckt. Die abgedeckten Bereiche werden anschließend durch ein reaktives Ionenätzverfahren mit Unterstützung von Halogenen im Reaktionsgas geätzt: Das im Beispiel verwendete Trockenätzverfahren verwendet ein $CF_4$-Plasma, welches mit Sauerstoff angereichert ist. Die Ätzung erfolgt hierdurch durch einen mechanischen Anteil ($CF_4/O_2$), welcher durch entsprechende Beschleunigung der Ionen zustande kommt, sowie einen chemischen Ätzanteil ($F^-$-Ionen).

Figur 10 zeigt den grundlegenden Aufbau eines freitragenden (also einen Abstandsbereich d zum Substrat aufweisenden) Balkens bzw. einer freitragenden AlGaN/GaN-Heterostruktur 2 auf einem Siliziumsubstrat 1, welcher bzw. welche mit Hilfe des anhand von Figur 9 beschriebenen Ätzprozesses hergestellt wurde. Der freitragende Balken 2 liegt am linken bzw. am rechten Ende auf dem Siliziumsubstrat 1 auf. In der Mitte zeigt das schematisch dargestellte Aktorelement einen Hohlraum H unterhalb der Halbleiterstruktur 2, welcher durch die in der Beschreibung von Figur 9 dargestellten Ätzprozesse erzeugt wurde. Die Tiefe der Kavität H beträgt etwa d=150 μm. Direkt auf der Oberseite (also auf der 20 nm dicken AlGaN-Deckschicht) der freitragenden aktiven Halbleiterstruktur 2 sind, wie im in Figur 2 gezeigten Fall, vier elektrische Zuleitungskontakte 3a1, 3b1, 3a2, 3b2 angeordnet (diese sind hier schematisch vereinfacht gezeichnet). Der bei Durchbiegung bzw. Auslenkung des Balkens 2 erzeugte elektrische Kontakt (Element 6, 8) ist hier vereinfacht nicht gezeichnet.

Figur 11 zeigt verschiedene Grundformen von Halbleiteraktoren. Die elektrischen Zuleitungskontakte sind zusammen mit den Ankerpunkten 4 hierbei schematisch gezeichnet, d.h. einer der gezeigten, quadratförmigen Kontakte 3 weist in der Regel wie in Figur 1 gezeigt vor der Substratbasiskante (d.h. auf einem mittels der Substratbasis 1 unterstützten Abschnitt 2b der Biegestruktur) einen ersten Zuleitungskontakt und auf der anderen Seite der Substratbasiskante, d.h. oberhalb des Hohlraums H im nicht mehr unterstützten Bereich 2a der Biegestruktur einen zweiten elektrischen Zuleitungskontakt auf. Benachbarte elektrische Zuleitungskontakte (welche dann über einen Stromfluss 7a oder eine Spannung 7b elektrisch zu verbinden sind) können sich jedoch auch zusammen oberhalb des freitragenden Abschnitts 2a befinden.

Figur 11 zeigt nicht die Erfindung, aber sieben verschiedene Ausgestaltungsformen eines Aktorelementes. In jeder der Teilfiguren 1A bis 1G ist eine Ausgestaltungsform in Aufsicht auf die Substratbasisschicht 1 gezeigt. Jede der Ausgestaltungsformen weist ein Siliziumsubstrat 1 sowie darauf angeordnet eine homogene Halbleiterschicht 2 bzw. einen nach Ausätzen einer gewünschten geometrischen Struktur verbliebenen Teil einer vormals das Substrat 1 vollständig bedeckenden Gesamtschicht auf. Ein Teil 2a der (verbliebenen) homogenen Halbleiterschicht 2 ist freitragend ausgeführt, d.h. oberhalb eines in das Substrat 1 eingeätzten Hohlraums 6 so angeordnet, dass der freitragende Teil 2a auslenkbar ist. Der freitragende Teil 2a bzw. die homogene Halbleiterschicht 2 ist mit dem Substrat 1 über eine unterschiedliche Zahl von Ankerpunkten 4 verbunden. In Figur 11A ist der freitragende, auslenkbare Teil 2a der homogenen Halbleiterschicht 2 mit der Substratbasis 1 über drei Ankerpunkte 4 so verbunden, dass der auslenkbare Teil 2a ein im wesentlichen y-förmiger Balken ist. Die drei

Ankerpunkte 4 sowie die zugehörigen Kontakte 3a-3c sind an den drei Enden des y- bzw. des entsprechenden Balkens angeordnet. In Figur 11B ist der freitragende, auslenkbare Teil 2a der homogenen Halbleiterschicht 2 mit der Substratbasis 1 über zwei auf derselben Seite des ausgeätzten Hohlraums H liegenden Ankerpunkte 4 der homogenen Halbleiterschicht 2 so verbunden, dass der freitragende, auslenkbare Teil 2a im wesentlichen einen U-förmigen Balken darstellt. Die beiden Ankerpunkte und die zugehörigen Kontakte 3a bis 3b sind an den beiden Enden des U bzw. des entsprechenden Balkens, somit also auf derselben Seite des Hohlraums H bzw. an einer Randseite des Hohlraums H, angeordnet. Figur 11C und Figur 11E zeigen einen freitragenden, auslenkbaren Teil 2a, der mit der Substratbasis so über vier Ankerpunkte 4 verbunden ist, dass der auslenkbare Teil 2a im wesentlichen einen X- oder H-förmigen Balken darstellt. Die vier Ankerpunkte sind an den vier Enden des X- bzw. des H-Balkens angeordnet. X- bzw. H-förmige Strukturen bieten den Vorteil, unterschiedliche Zuleitungspfade wählen zu können bzw. die für die elektrische Zuleitung verwendeten Kontakte der gezeigten Kontakte 3a bis 3d auswählen zu können. Figur 11D zeigt einen Fall, in dem der freitragende, auslenkbare Teil 2a der homogenen Halbleiterschicht 2 mit der Substratbasis 1 über eine Vielzahl von Ankerpunkten 4 so verbunden ist, dass der freitragende, auslenkbare Teil 2a im wesentlichen einen doppelkammförmigen Balken darstellt. Die Ankerpunkte 4 bzw. Kontakte 3a, 3b sind jeweils an den Enden der Kammzinken bzw. den einzelnen Balkenenden angeordnet. Die Kammform hat gegenüber normalen geraden Balken den Vorteil eines empfindlicheren Auslenkungsverhaltens. Figur 11F zeigt den Fall aus Fig. 1, in dem ein freitragender, auslenkbarer Teil 2a der homogenen Halbleiterschicht 2 mit der Substratbasis 1 über genau einen Ankerpunkt 4 so verbunden ist, dass ein freistehender, auslenkbarer geradliniger Balken entsteht. Der Ankerpunkt 4 ist an einem der Enden des Balkens angeordnet, der Kontakt 3 am Ankerpunkt 4. Figur 11G zeigt einen Fall, in dem ein freitragender, auslenkbarer Teil 2a mit der Substratbasis 1 über genau zwei Ankerpunkte 4 so verbunden ist, dass ein beidseitig eingespannter, freitragender geradliniger Balken entsteht. Die beiden Ankerpunkte 4 befinden sich an den beiden Enden des geradlinigen Balkens, ebenso die zugehörigen Kontakte 3a, 3b. Die Strukturen mit mindestens zwei direkt gegenüberliegenden Ankerpunkten 4, d.h. von oben gesehen mit Ankerpunkten 4 auf zwei gegenüberliegenden Seiten des ausgeätzten Hohlraums 6, haben den Vorteil, dass über die entsprechenden Balken durch Auslenkung des Zentrums eine Verspannung über der gesamten Fläche, also zusätzlich neben einer Dehnung und einer Stauchung in den Biegeradien auch eine Verlängerung des Balkens und somit auch eine Dehnung der Elementarzellen erreicht werden kann.

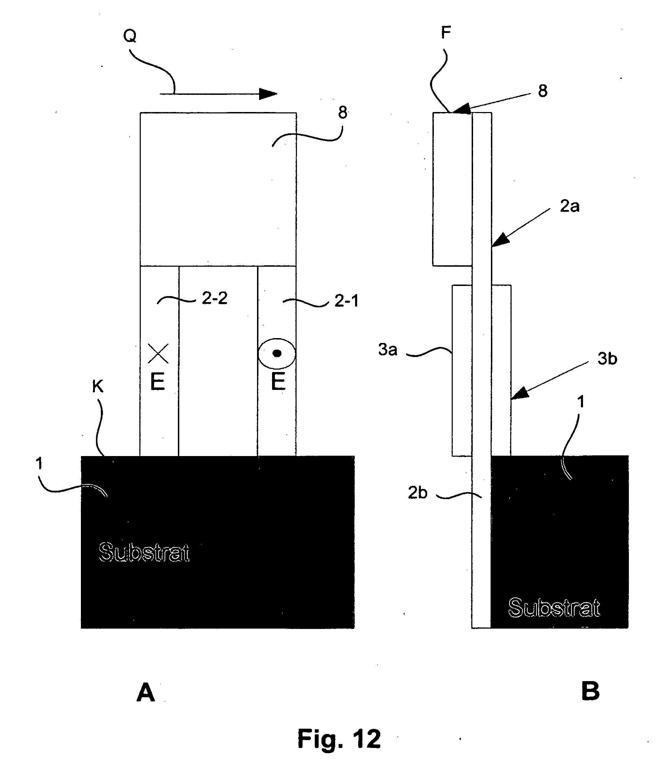

Figur 12 zeigt nicht die Erfindung, aber eine weitere Realisierungsmöglichkeit eines Halbleiteraktors, welcher eine Querauslenkung ermöglicht (Fig. 12A: Aufsicht senkrecht zur Platinenebene, Fig. 12B: Seitenansicht senkrecht dazu und senkrecht zur Balkenlängsrichtung). Figur 12A zeigt also eine Draufsicht senkrecht auf die Ebene, die von den beiden Balken 2-1 und 2-2 aufgespannt wird, Figur 12B zeigt eine Seitenansicht in der Ebene senkrecht dazu. Die Biegestruktur 2 ist hier als homogene Halbleiterstruktur (GaN, AlN, InN oder auch als ternäre Verbindung) realisiert. Ternäre Verbindungen sind Kombinationen aus zwei Hauptgruppe-III-Elementen (Al, In, Ga) mit Stickstoff (N) zu $In_xAl_{1-x}N$ oder $Al_xGa_{1-x}N$ im Unterschied zu den binären Materialien der Gruppe-III-Nitride (AlN, InN, GaN). Prinzipiell kann an jeder Stelle erfindungsgemäß anstatt eines binären Materials ein geeignetes ternäres eingesetzt werden oder umgekehrt (bei geeigneter Wahl von x aus [0,1]). Beispiel: AlGaN/GaN kann auch als AlN/GaN-Variante, als AlN/AlGaN-Variante, als InAlN/GaN-Variante oder als GaN/AlGaN-Variante eingesetzt werden. Die Biegestruktur besteht hierbei aus zwei parallel angeordneten Einzelbalken 2-1, 2-2, welche beabstandet voneinander mit ihrem jeweiligen unterstützten Abschnitt 2b auf der Substratbasis 1 angeordnet sind und über die Substratbasiskante K mit ihrem freistehenden Abschnitt 2a senkrecht zur Kante K hinausragen. An ihrem freistehenden, der Basis 1 abgewandten Ende weist die Balkenstruktur 2 eine Aktuatorspitze 8 aus einem Metallelement auf, welches auf der der Substratbasis 1 abgewandten Oberseite der Balkenstruktur 2 angeordnet ist und die beiden parallel verlaufenden Balken 2-1 und 2-2 verbindet. Die Aktuatorspitze ist z.B. hier auf der der Balkenstruktur 2 abgewandten Seite mit einer reflektierenden Schicht versehen, und lässt sich somit als Spiegel für Laserlicht einsetzen. Hierbei wird die "Dicke" der Metallisierung (Fläche F in Fig. 12B senkrecht zur von den Balken aufgespannten Ebene und auf der Substrat-abgewandten Seite) als Spiegel verwendet, da diese einer Rechts-Links-Bewegung unterzogen wird. Im freistehenden Bereich 2a zwischen der Aktuatorspitze 8 und der Substratbasis 1 weist jeder der beiden Balken 2-1, 2-2 der Biegestruktur 2 jeweils auf seiner Oberseite einen ersten elektrischen Zuleitungskontakt 3a und diesem gegenüberliegend auf seiner Unterseite einen zweiten elektrischen Zuleitungskontakt 3b auf. Bei Kontaktierung dieser beiden elektrischen Zuleitungskontakte (welche sich in Beziehung auf die Längsrichtung der Balken gesehen gegenüberliegen) mit einer Spannung, wird über den Querschnitt des jeweiligen Balkens in Richtung senkrecht zu der von den beiden Balken aufgespannten Ebene ein elektrisches Feld E im Balken induziert. Wird wie in Figur 12A links gezeigt der erste Balken 2-1 anders gepolt als der zweite Balken 2-2 (so dass im Balken 2-1 eine Feldrichtung des elektrischen Feldes E aus der gezeigten Ebene heraus und im Balken 2-2 eine Feldrichtung entgegengesetzt dazu in die gezeigte Ebene hinein resultiert), so bewirken diese vertikal zum jeweiligen Balken entgegengesetzt gerichteten Felder pro Balken eine unterschiedliche Längenänderung (in Balkenlängsrichtung) in der Ebene, welche von den Balken aufgespannt wird. Durch unterschiedliche elektrische Felder im einen Balken 2-1 und im anderen Balken 2-2 (auch beispielsweise durch gleichgerichtete Felder, welche eine unterschiedliche Feldstärke aufweisen) wird somit eine Querbewegung (Richtung Q im wesentlichen entlang der Kante K) des oberen Bereichs 8 erzeugt.

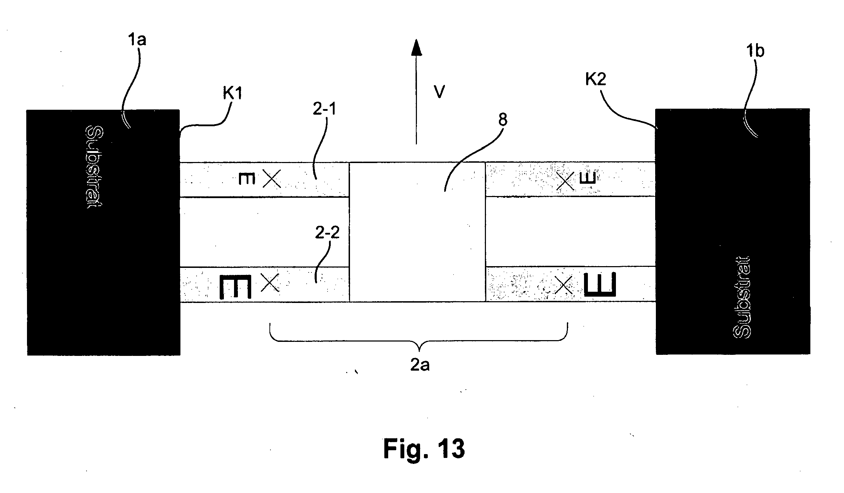

Figur 13 zeigt nicht die Erfindung, aber eine weitere Möglichkeit eines doppelt eingespannten Doppelbalkens, welche grundsätzlich wie die in Figur 12 gezeigte Variante aufgebaut ist, jedoch die Aktuatorspitze 8 in der Mitte eines freitragenden Abschnitts 2a zweier doppelseitig parallel zueinander eingespannter Balken 2-1 und 2-2 aufweist.

Wird nun beispielsweise am Balken 2-1 eine kleinere elektrische Feldstärke (Kontakte 3a1, 3b1, 3a2, 3b2 hier nicht gezeigt) angelegt als am Balken 2-2 (wobei die Richtung der beiden Felder hier gleichgerichtet ist), so ergibt sich eine seitliche Verschiebung (Richtung V in der durch die Balken 2-1 und 2-2 aufgespannten Ebene und entlang der Kanten K1 und K2) des doppelt eingespannten Balkens in der Ebene, welche durch die Balken 2-1 und 2-2 aufgespannt wird. Auch Figur 13 zeigt somit die Draufsicht auf einen Balken mit der Möglichkeit zur Querauslenkung.

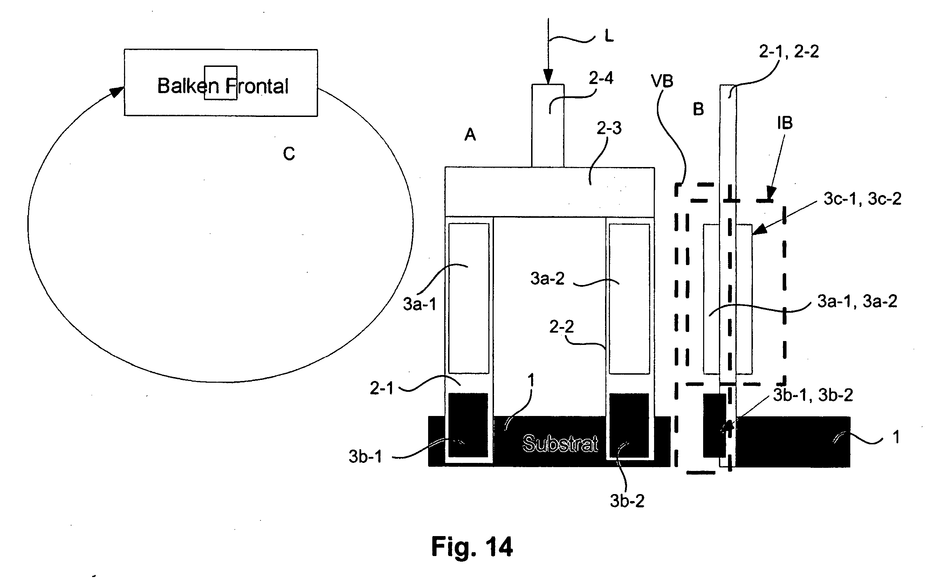

Figur 14 zeigt nicht die Erfindung, aber eine weitere Ausgestaltung eines Halbleiteraktors: Figur 14A in Draufsicht senkrecht zur Platinenebene, Figur 14B in Seitenansicht in Richtung der Platinenebene und senkrecht zur Balkenlängsachse und Figur 14C in Seitenansicht in der Platinenebene und in Richtung der Balkenlängsachse. Der Halbleiteraktor umfasst hier wie in Fig. 12 zwei parallel zueinander und beabstandet voneinander auf dem Substrat 1 angeordnete, freistehende Längsbalken 2-1 und 2-2. An ihrem freistehenden, der Substratbasis 1 abgewandten Ende sind die beiden Balken über einen Querbalken 2-3 miteinander verbunden. Der Querbalken 2-3 trägt typischerweise, jedoch nicht notwendigerweise mittig zwischen den beiden Balken 2-1 und 2-2 auf der diesen beiden Balken gegenüberliegenden Seite eine Spitze 2-4, an welcher beispielsweise ein leitfähiges Kontaktelement (nicht gezeigt) angeordnet werden kann. Auf der der Substratbasis abgewandten Oberseite trägt jeder der beiden Balken 2-1 und 2-2 jeweils zwei Kontakte: Einen legierten Ohmschen Kontakt 3b-1, 3b-2, welcher sich teilweise im Bereich 2b oberhalb der Substratbasis und teilweise im freistehenden Bereich 2a erstreckt, sich jedoch auch nur auf einer der beiden Seiten beschränken kann, und beabstandet davon im freistehenden Abschnitt 2a einen nicht legierten Schottky-Kontakt 3a-1, 3a-2. Diesem Schottky-Kontakt 3a-1, 3a-2 gegenüberliegend befindet sich auf der Unterseite des freistehenden Balkenabschnitts 3a jeweils ein zweiter, nicht-legierter Schottky-Kontakt 3c-1, 3c-2.

Die gezeigte Balkenkonstruktion kann nun durch geeignete Beschaltung der Kontakte und eine dadurch verursachte Kombination einer Längsdehnung oder Längsstauchung und einer Aufwärts- oder Abwärtsbewegung eine Kreisbewegung, wie sie in Figur 14C angedeutet ist, ausführen (Figur 14C zeigt eine Ansicht in Richtung der Balkenlängsachse L, siehe Figur 14A). Bei geeigneter Wahl der am jeweiligen Balken 2-1 und 2-2 angelegten elektrischen Felder (siehe auch Erklärungen zu den vorstehenden Figuren) ergibt sich bei Anlegen von Spannungen zwischen den Kontakten 3a-1 und 3c-1 sowie zwischen 3a-2 und 3c-2 (Beschaltung IB) eine Bewegung in derjenigen Ebene, welche durch die beiden Balken 2-1 und 2-2 aufgespannt wird (Link-Rechts-Bewegung in Figur 14A durch unterschiedliche Längsdehnungen bzw. Stauchungen der beiden Balken 2-1 und 2-2). Durch Anlegen von Spannungen zwischen den Kontakten 3b-1 und 3a-1 sowie zwischen 3b-2 und 3a-2 (Beschaltung VB) ergibt sich eine Bewegung vertikal zur Ebene, die von den beiden Balken aufgespannt wird (dies entspricht einer Bewegung wie sie in Figur 1 beschrieben wird). Durch Kombination der beiden beschriebenen Spannungsschaltungen ist dann eine Bewegung, wie sie in Figur 14C gezeigt ist, möglich. In einer alternativen Variante kann hierbei auch der Ohm-Kontakt 3b-1 bzw. 3b-2 auf der Unterseite im Bereich 2a der Balken angeordnet werden.

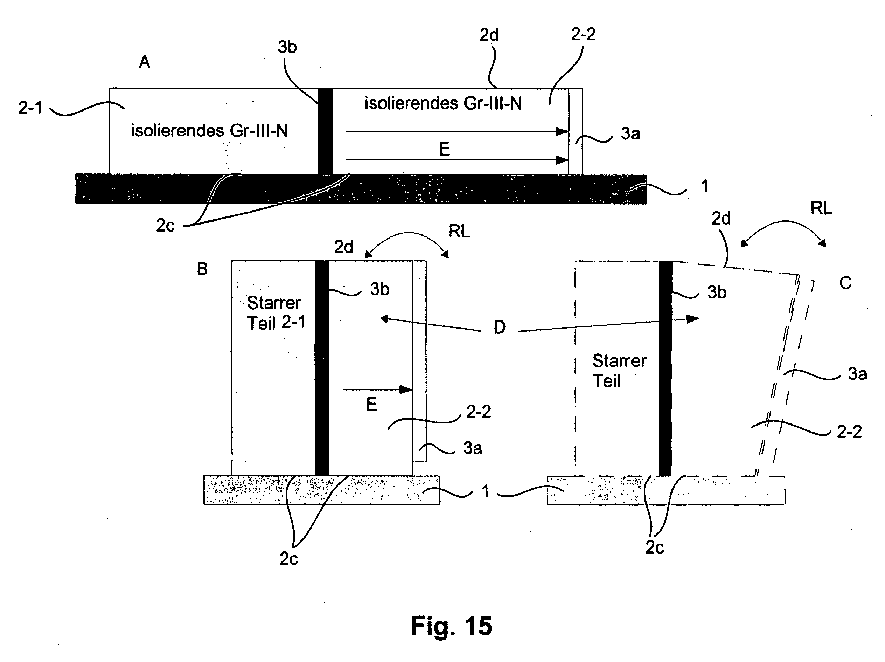

Figur 15 zeigt nicht die Erfindung, aber eine weitere Variante eines Halbleiteraktors. Zum Aufbau dieses Halbleiteraktors wird ein Block 1 aus einem Siliziumsubstrat verwendet. Das verwendete Substrat ist hierbei ein Substrat mit anderer Kristallorientierung, nicht ein 111-Substrat (etwa ein 100-Si-Substrat oder ein Saphirsubstrat mit Orientierung R-Ebene (1-102) oder A-Ebene (11-20) anstatt C-Ebene (0001)). Dies bewirkt, dass der normalerweise auf dem 111-Si-Substrat vertikal bzw. senkrecht zum Substrat stehende Dipol der Halbleiterverbindung auf Basis von Nitriden von Hauptgruppe-III-Elementen für eine bessere Effizienz in die Waferebene gekippt wird: Durch Verwendung eines solchen Substrats und von geeigneten Wachstumsbedingungen steht dieser Dipol nicht mehr unter einem rechten Winkel, sondern schräg bzw. unter einem Winkel kleiner 90° zu der Grenzfläche zwischen Substrat 1 und Halbleiterstruktur 2 (siehe vorstehende Beschreibungsabschnitte zur Verwendung der 100-bzw. 110-Substrate).

Angrenzend an den Substratblock 1 ist ein Block 2 aus homogenem GaN (es kann sich alternativ auch um AlN, InN oder um eine ternäre Verbindung handeln) angeordnet. In diesem Block ist mittig und senkrecht zum Substratblock 1 stehend durch Implantation eine leitfähige Schicht bzw, eine Elektrode 3b erzeugt worden. Durch diese Elektrode 3b wird somit der Block aus GaN in einen ersten Bereich 2-1 (nachfolgend: starrer Teil) und einen zweiten Bereich 2-2 (nachfolgend: dehnbarer bzw. stauchbarer Bereich) unterteilt. Beide Teile 2-1 und 2-2 bzw. der Block 2 sind an ihrer der Basis 1 zugewandten Seite fest mit der Basis 1 verbunden (Grenzfläche 2c). Auf der der Elektrode 3b gegenüberliegenden Seite des dehnbaren bzw. stauchbaren Bereichs 2-2 ist auf dessen an den Substratblock 1 angrenzender, senkrecht zur Oberfläche des Substratblocks 1 stehenden Oberfläche eine zweite Elektrode 3a (Metallschicht) aufgebracht. Durch Anlegen einer Spannung zwischen den beiden Elektroden 3b und 3a ist somit im dehnbaren bzw. stauchbaren Bereich 2-2 ein elektrisches Feld E erzeugbar. Der dehnbare bzw. stauchbare Bereich ist auch mit dem Buchstaben D bezeichnet. Wird nun eine Spannung zwischen diesen beiden Elektroden angelegt, so lässt sich eine effektive Rechts-Links-Bewegung RL erzeugen, da das Material des D-Bereichs sich durch das elektrische Feld E auf der dem Substratblock 1 abgewandten Seite 2d dehnen bzw. stauchen lässt (je nach Feldrichtung). An der dem Substrat 1 zugewandten Seite 2c findet keine Dehnung bzw. Stauchung des D-Bereichs 2-2 statt, da diese Seite fest mit der Substratbasis 1 verbunden ist. Während einer solchen Dehnung oder Stauchung ändert der starre Teil 2-1 seine Lage nur wenig, da dieser ebenfalls fest mit dem Substrat 1 verbunden ist und da in ihm kein elektrisches Feld E erzeugt wird (es liegt somit ein ähnlicher Aufbau vor wie bei einem klassischen Bimetall). Je nach Geometrie und Materialparametern kann es aber auch zu einer geringfügigen Auslenkung des starren Teils kommen.

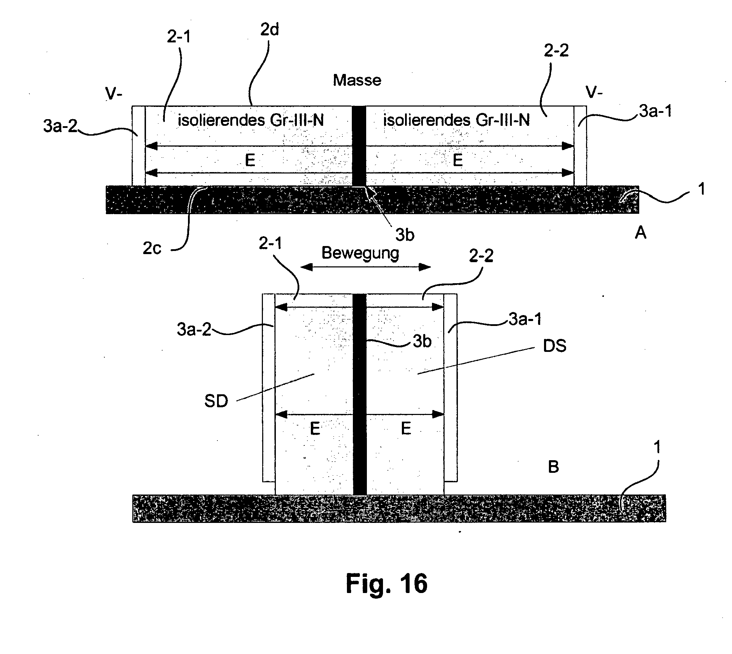

Figur 16 zeigt nicht die Erfindung, aber einen symmetrischen Aufbau, welcher auf dem Aufbau, wie er in Figur 15 gezeigt ist, basiert: Zusätzlich ist hier auch auf der der Elektrode 3a (hier: 3a-1) gegenüberliegenden Seite der GaN-Struktur 2 eine zweite Elektrode 3a-2 angeordnet. Somit lässt sich auch in dem vormals starren Bereich 2-1 ein elektrisches Feld E erzeugen. Erfolgt somit beispielsweise eine Beschaltung wie sie in Figur 16A gezeigt ist, nämlich dass die mittige zentrale Elektrode 3b an Masse liegt, dass die Elektrode 3a-1 mit einem negativen Potential V- beaufschlagt wird (Fig. 16A) und dass ebenfalls die Elektrode 3a-2 mit einem negativen Potential V-beaufschlagt wird, so ergibt sich die in Figur 16B gezeigte Bewegung: Der GaN-Abschnitt 2-2 wird auf seiner dem Substratblock 1 abgewandten Seite 2d einer Dehnung D unterworfen, während es aufgrund der im Abschnitt 2-1 vorliegenden umgekehrten Feldrichtung in diesem GaN-Abschnitt auf der der Substratbasis 1 abgewandten Seiten 2d zu einer Stauchung S kommt. Bei Anlegen von positiven Potentialen an die Elektroden 3a-2 und 3a-1 lässt sich dies umkehren, so dass im Bereich 2-1 eine Dehnung D und im Bereich 2-2 eine Stauchung S erfolgt. Dies ist in den Figuren durch die Bezugszeichen SD und DS gekennzeichnet.

Figur 17 zeigt nicht die Erfindung, aber eine weitere Variante, welche grundsätzlich ähnlich wie die in Figuren 15 und 16 gezeigten Varianten aufgebaut ist. In diesem Fall wird jedoch auf die mittige zentrale Elektrode 3b verzichtet. Somit ergibt sich in Figuren 17A und 17B ein an der Substratbasis 1 angeordneter Block aus GaN, an dessen beiden senkrecht zum Substratblock 1 stehenden und an den Substratblock 1 angrenzenden Stirnseiten jeweils Metallelektroden 3a-1 und 3a-2 ausgebildet sind. Diese Variante wurde so realisiert, dass die C-Achse des Piezodipols des GaN-Blocks parallel zur Grenzfläche zwischen Substratblock 1 und GaN-Block 2 verläuft (siehe Figur 17A). Wird nun eine Spannung zwischen den Elektroden 3a-1 und 3a-2 angelegt (siehe Variante a in Figur 17B), so kommt es auf der dem Substratblock 1 abgewandten Seite 2d des GaN-Blocks 2 zu einer Dehnung bzw. Stauchung DS je nach angelegter Feldstärke. Die Mitte M des GaN-Blocks bleibt dabei in Ruhe, wird also nicht ausgelenkt.

Figur 17C zeigt eine weitere Variante (Variante b), bei welchem die Elektroden 3a-1 und 3a-2 nicht auf den senkrecht zum Substrat 1 stehenden Stirnseiten des GaN-Blocks 2 angeordnet sind, sondern bei denen die Elektrode 3a-1 angrenzend an die Substratbasis 1 und zwischen dieser und dem GaN-Block 2 eingearbeitet ist und bei der die Elektrode 3a-2 auf der Substratbasis abgewandten Seite 2d des GaN-Blocks 2 aufgebracht ist. Wird hier nun zwischen diesen beiden Elektroden eine Spannung angelegt und somit im Block 2 ein elektrisches Feld E erzeugt, so kommt es je nach angelegter Feldstärke und Feldrichtung zu einer Dehnung bzw. Stauchung DS senkrecht zur Grenzfläche zwischen Substratbasis 1 und Block 2 bzw. Elektrode 3a-1, also in Richtung des elektrischen Feldes E. Die Längenänderung ist hier mit dem Buchstaben L bezeichnet.

Die Figuren 15 bis 17 beschreiben hierbei den optimalen Fall, dass es epitaktisch durch geeignete Substratwahl und/oder Substratpräparation und Wachstumsbedingungen erreicht wurde, die c-Achse des GaN-Kristalls (und damit den Dipol) in die Waferebene zu kippen (parallel zur Grenzfläche zwischen Substrat 1 und Halbleiterstruktur 2). Hierbei sind natürlich alle Zwischenstufen der Dipolausrichtung, also auch Winkel zwischen der besagten Grenzfläche und dem Dipol von größer als 0° und kleiner als 90° denkbar.

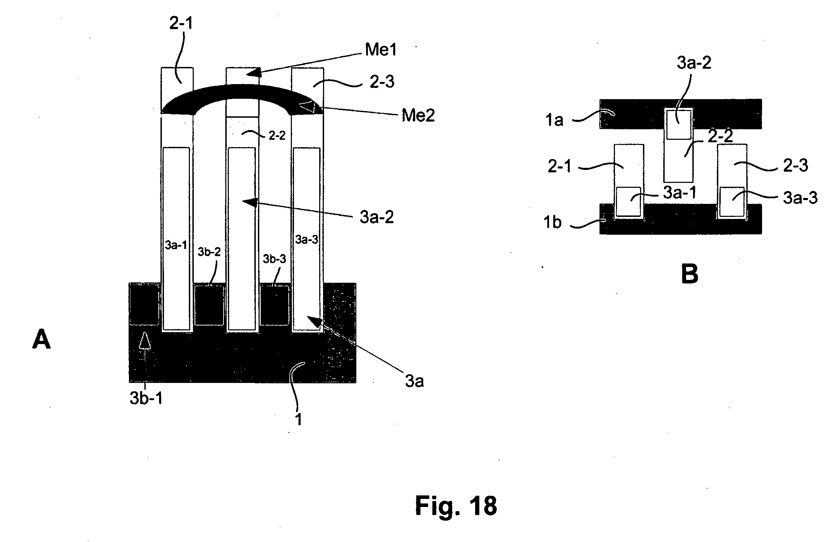

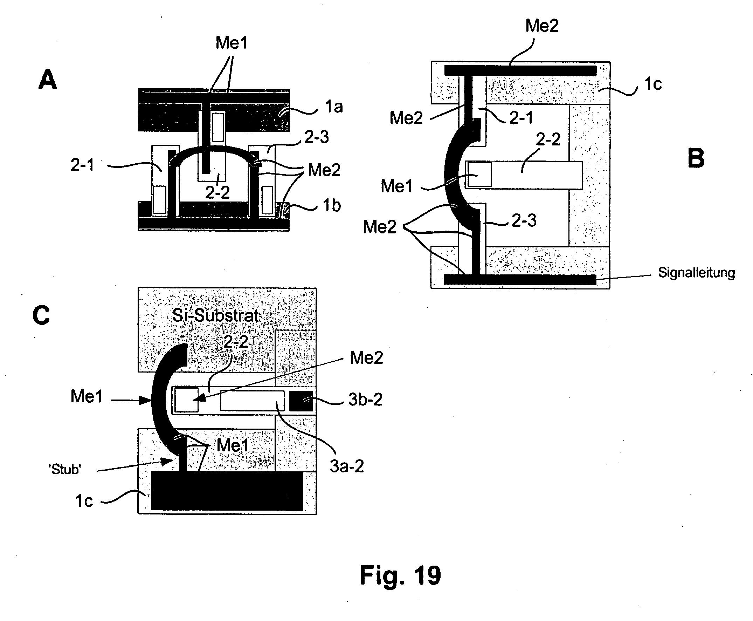

Ein weiteres Ausführungsbeispiel für eine Varaktorstruktur eines erfindungsgemäßen Halbleiteraktors zeigt Figur 18 (Draufsicht auf die Platinenebene, Platine nicht gezeigt). Auf der Substratbasis 1 sind hier drei freistehende Balken 2-1, 2-2 und 2-3 parallel zueinander und beabstandet voneinander angeordnet. Jeder dieser Balken 2 ist als Heterostruktur, wie sie beispielsweise in Figur 3 beschrieben wurde, ausgestaltet. Gezeigt sind die oberen Kontakte 3a-1, 3a-2, 3a-3, jeweils auf der Oberseite des jeweiligen Balkens. Im gezeigten Beispiel sich erstreckend vom unterstützten Bereich 2b der Balken bis in den freistehenden Bereich 2a. Diese Geometrie ist jedoch nicht zwingend erforderlich (die Kontakte 3a-1, 3a-2, 3a-3 sind teil- oder vollflächige Kontakte auf den Balkenoberseiten mit variabler Geometrie; lediglich die Kontaktierung zu einer Spannungsversorgung für die Auslenkung des Aktors muss gewährleistet sein. Die Dimension und Lage der Kontaktflächen auf der Balkenoberseite beeinflusst die Effizienz der Auslenkung und die erreichbare Auslenkung). Die Heterostruktur-Grenzflächenelektrode ist hier aufgrund der gewählten Draufsicht nicht sichtbar; lediglich sichtbar ist ein Teil eines elektrischen Kontakts, welcher diese Heterostruktur-Grenzflächenelektrode hier im Beispiel seitlich kontaktiert (auf der Substratbasis 1 jeweils seitlich neben den Balkenabschnitten 2b angeordnete legierte Ohm-Kontakte 3b-1, 3b-2 und 3b-3, welche jeweils die 2D-Elektronengase der einzelnen Balken 2-1, 2-2 und 2-3 kontaktieren). Auch für die Größe und Lage dieser Kontakte ist eine nahezu beliebige Form und Lage möglich, da nur eine Verbindung zu dem 2D-Elektronengas bzw. dem leitfähigen Kanal ermöglicht werden muss. Daher ist es auch stets möglich, für mehrere Balken einen gemeinsamen Kontakt zu verwenden, falls das 2D-Elektronengas nicht unterbrochen ist (etwa durch Ätzung). Die Kontakte 3a-1, 3a-2 und 3a-3 sind jeweils als nicht-legierte Schottky-Kontakte ausgebildet. Durch Anlegen von Spannungen zwischen den jeweiligen Kontakten 3a und 3b können die Balken unabhängig voneinander betrieben werden: Jeder Balken kann somit einzeln vertikal zur gezeigten Ebene bei Anlegen einer entsprechenden Spannung ausgelenkt werden. Auf dem der Substratbasis 1 gegenüberliegenden, freistehenden Ende weist nun der mittlere, zwischen den beiden Balken 2-1 und 2-3 angeordnete Balken 2-2 auf seiner Oberseite eine Metallisierung Me1 auf. Die beiden äußeren Balken 2-1 und 2-3 weisen an ihrem der Substratbasis 1 abgewandten freistehenden Ende eine elektrisch leitfähige Verbindung Me2 auf, welche als metallisierte, über den Balken 2-2 hinwegreichende Brücke so ausgebildet ist, dass in der Ruhelage die Metallisierung Me1 und die Metallisierung Me2 sich nicht berühren. Durch geeignete Anlegen einer Spannung entweder an die Balken 2-1 und 2-3 oder an den Balken 2-2 (die beiden Balken 2-1 und 2-2 werden hier jeweils parallel betrieben mit der gleichen Spannung) lässt sich der Abstand zwischen der Metallisierung Me1 und der Metallisierung Me2 verringern (Betrieb etwa als Varaktor) bzw. sogar ein Kontakt schließen (Betrieb als Schalter): Balken 2-2 wird somit einzeln und mit unterschiedlicher Spannung (hier: zwischen den Elektroden 3a-2 und 3b-2) zwischen den beiden anderen jeweils mit derselben Spannung beaufschlagten Balken 2-1 und 2-3 betrieben bzw. ausgelenkt. Gegenüber dieser in Figur 18A gezeigten Variante unterscheidet sich die in Figur 18B gezeigte Variante darin, dass lediglich die beiden Balken 2-1 und 2-3 an einer ersten Substratbasis (hier: 1b) angeordnet sind (die Metallisierungen wurden zur vereinfachten Darstellung weggelassen). Beabstandet zur Substratbasis 1b ist auf der nicht gezeigten Platine dann eine zweite Substratbasis 1a angeordnet, auf der der mittlere Balken 2-2 aufgebracht ist. Dieser Balken 2-2 ragt somit von der gegenüberliegenden Seite reißverschlussförmig zwischen die beiden Balken 2-1 und 2-3 ein. Die Substratbasis 1a kann dabei als zweite, separat von der Substratbasis 1b realisierte Substratbasis ausgebildet werden. Es ist jedoch auch möglich, die Basen 1a, 1b als einzelnen Chip direkt herzustellen (der dazu notwendige, nach dem Ätzen verbleibende Restsubstratanteil, der die Anordnung außen umschließt, damit eine stabile mechanische Verbindung erhalten bleibt, ist nicht gezeigt). Vorteil letzterer Realisierung: Es ist keine Justage, welche eine hohe Justagegenauigkeit erfordert, notwendig. Der Vorteil der in Figur 18B gezeigten Anordnung ist, dass Platz für Zuleitungen und Schaltungen auf beiden Seiten genutzt werden kann. Zudem können (wie nachstehend in Figur 19A gezeigt) zwei Schaltungen kapazitiv oder auch, wie nachfolgend noch näher beschrieben, induktiv miteinander verkoppelt werden.

Figur 19 zeigt nun wie ein elektrisches Nutzsignal bei der Auslenkung der Balken, wie sie in Figur 18 gezeigt sind, geführt werden kann (Figur 19 zeigt ebenfalls Aufsichten auf die Platinenebene (Platine nicht gezeigt)): Die Auslenkung der Balken verändert dann die Kapazität im Signalpfad (das elektrische Nutzsignal kann somit entlang der Balken geführt werden). Figur 19A zeigt die in Figur 18B gezeigte Variante. Auf der Oberfläche der Balken 2-1 und 2-3 sowie auf dem angrenzenden unterstützenden Substrat 1b ist hier ein Signalpfad Me2 zu erkennen, welcher den schon in Figur 18 vorbeschriebenen Brückenabschnitt, zwei parallel zur Balkenlängsachse der Balken 2-1 und 2-3 auf deren Oberflächen verlaufende Abschnitte sowie einen senkrecht zu diesen Abschnitten und mit beiden Abschnitten auf den Balken verbundenen, auf dem Substrat 1b verlaufenden Abschnitt umfasst (all diese Abschnitte sind hier mit dem Bezugzeichen Me2 bezeichnet). Auf dem von der gegenüberliegenden Seite einragenden Balken 2-2 verläuft ebenfalls ein Teil eines Signalpfadabschnittes Me1, wobei letzterer einen parallel zur Balkenlängsachse auf der Oberfläche des Balkens 2-2 verlaufenden Abschnitt sowie einen senkrecht dazu auf der Oberfläche des Substrats 1a verlaufenden Abschnitt umfasst.

Figur 19B zeigt eine weitere Variante eines erfindungsgemäßen Varaktors: Hier ist das Substrat 1c in U-Form ausgebildet. Die Basis des U trägt den mittleren Balken 2-2, während die beiden Schenkel des U an ihren der Basis des U abgewandten Enden jeweils einen der Balken 2-1 und 2-3 tragen. Die Balken 2-1 und 2-3 sind hierbei senkrecht zur Längsachse der U-Schenkel angeordnet, ragen somit im 90°-Winkel, d.h. mit ihrer Längsachse senkrecht zur Längsachse des Balkens 2-2 in den Innenhof des U hinein. Die beiden Balken 2-1 und 2-3 sind auf ihrer Oberfläche wieder durch einen Brückenabschnitt, welcher sich wie die vorbeschriebenen Brückenabschnitte in der Ruhelage mit einem Abstand zur Metallisierung Me1 des Balkens 2-2 oberhalb dieser erstreckt, ausgestattet. Weitere Abschnitte des Signalpfades Me2 der Balken 2-1 und 2-3 erstrecken sich entlang der Balkenlängsachse der Balken 2-1 und 2-3 auf deren Oberfläche sowie im 90°-Winkel hierzu entlang der Längsachsen der U-Schenkel. Auch hier lässt sich durch eine Veränderung des Abstands der Metallisierung Me1 zum Brückenabschnitt der Metallisierung Me2 die Kapazität des Signalpfades verändern.

Figur 19C zeigt eine weitere Variante, welche grundsätzlich bis auf die nachfolgend beschriebenen Unterschiede wie die in Figur 19B gezeigte Variante aufgebaut ist. Der Balken 2-2 trägt hierbei auf seiner Oberseite neben der Metallisierung Me2 am freistehenden Ende auch beabstandet davon einen nicht-legierten Schottky-Kontakt 3a-2 (welcher sich im Beispiel vom freistehenden Bereich 2a in den unterstützten Bereich 2b des Balkens und auf dessen Oberseite erstreckt, wobei wie vorstehend beschrieben auch andere Geometrien zulässig sind) sowie einen legierten Ohmkontakt 3b-2, welcher im Beispiel am unterstützten Endes des Balkens beabstandet vom Schottky-Kontakt 3a-2 zur Kontaktierung entsprechend Fig. 1 oder Fig. 3 angeordnet ist . Auch hier gilt, dass wie vorstehend beschrieben eine nahezu beliebige Form und Lage möglich ist, wenn eine Verbindung zu dem 2D-Elektronengas bzw. dem leitfähigen Kanal des Balkens ermöglicht wird. Das Metallpad Me2 auf dem Balken 2-2 kann hierbei auf seiner der Balkenoberfläche abgewandten Seite mit einer Isolationsschicht versehen (beispielsweise SiN, $SiO_2$ oder $Al_2O_3$). Diese Isolationsschicht dient der Verhinderung eines Verklebens mit dem später noch näher beschriebenen Brückenabschnitt der Metallisierung Mel. Das Vorsehen einer solchen Isolationssschicht ist jedoch nicht notwendig: Ein elektrisch leitender Kontakt ist ja nicht erforderlich im Falle der kapazitiven Kopplung, bei dem wie vorbeschrieben die Kapazität mit dem Abstand der Elemente verändert wird (es ist auch eine induktive Kopplung, wie sie nachfolgend noch näher beschrieben wird, möglich). Die Isolationsschicht wird daher dazu verwendet, die Dielektrizitätskonstante bei der kapazitiven Kopplung zu beeinflussen und ein Verkleben der beiden Metalle (falls doch ein Kontakt zustande kommt) zu vermeiden.

Die beiden U-Schenkel weisen nun im Gegensatz zum in Figur 19B gezeigten Fall keine Balkenstrukturen auf, die Elemente 2-1 und 2-3 entfallen somit hier. Stattdessen erstreckt sich auf Höhe des freistehenden Endes des Balkens 2-2, also oberhalb des Metallpads Me2, ein Brückenabschnitt der Metallisierung Me1, welcher sich vom einen zum anderen U-Schenkel erstreckt. Lediglich auf einem der U-Schenkel (hier: unterer Schenkel) erstreckt sich dann ausgehend vom Ende des Brückenabschnitts ein weiteres Leitungselement der Metallisierung Me1 auf der Oberfläche des U-Schenkels der Substratbasis 1 in Form eines Hochfrequenzsignalpfades (RF-Signalpfad). Diese einseitige Konfiguration wird auch als "Mätching Stub" bezeichnet. Bei einem solchen "Matching Stub" ist somit auf der einen Seite (oberer U-Schenkel) lediglich eine "Landefläche" der Metallisierung Me1 ausgebildet, während auf der anderen Seite (unterer U-Schenkel) eine "Stub"-Verbindung der Metallisierung von dem Brückenelement zum RF-Signalpfad führt. Natürlich ist es auch entsprechend möglich, eine oder beide Seiten mit einem Balken 2-1 oder 2-3, wie er in Figur 19B gezeigt ist, auszustatten. Die Konfiguration als Matching Stub mit nur einseitiger Zuleitung einer Beschaltung kann aber auch eine Beschaltung, wie sie beispielsweise in Figur 7B gezeigt ist, erfahren (wobei also eine Zuleitung auf beiden Seiten erfolgt).

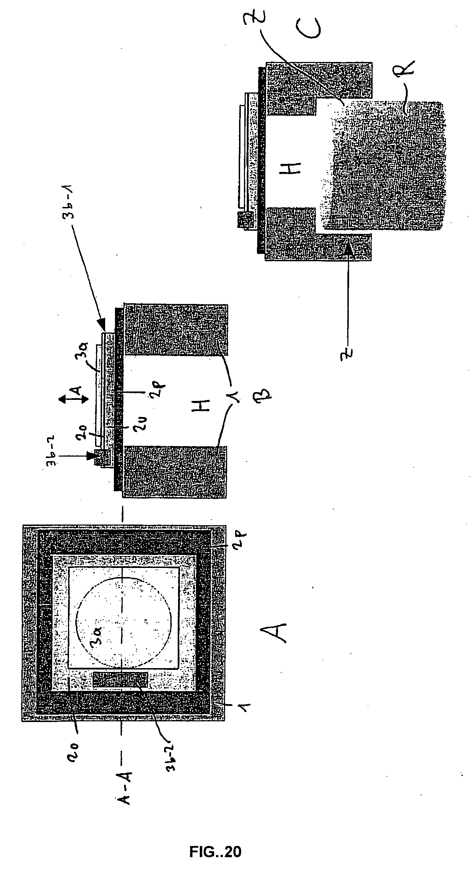

Figur 20 zeigt ein weiteres Ausführungsbeispiel, in welchem der erfindungsgemäße Halbleiteraktor als mikromechanische Membranpumpe ausgebildet ist, bei der sich eine Membran hebt und senkt. Figur 20A zeigt eine Aufsicht auf diese Membranpumpe, Figur 20B eine Schnittansicht senkrecht dazu entlang der Schnittlinie A-A. Das Substrat 1 ist hier als quaderförmiger Block ausgebildet, aus dem zentrisch ein zylinderförmiger Hohlraum H ausgeätzt wurde (in der Ansicht von oben: kreisförmig eingezeichneter Bereich im Kontaktbereich 3a), so dass vom ursprünglichen Substratblock lediglich außenumfangseitig diesen Hohlraum H umschließende Seitenwände 1 stehen geblieben sind. Der Hohlraum H wird dann, wie nachfolgend näher beschrieben, durch eine Halbleiterpufferschicht und eine aktive Halbleiterschicht zur Oberseite hin, d.h. zur platinenabgewandten Seite hin, vollständig abgedeckt. Um dies zu realisieren, liegt die (hier im Beispiel, aber nicht notwendigerweise, rechteckförmige) Pufferschicht 2p aus einer Halbleiterverbindung auf Basis von Nitriden von Hauptgruppe-III-Elementen entlang ihres Außenumfangs vollständig und zentriert auf den Substratwänden 1 auf. Auf dieser Pufferschicht 2p ist dann zentrisch eine (hier im Beispiel auch, aber nicht notwendigerweise, rechteckförmige), aktive Schicht aus einer AlGaN/GaN-Heterostruktur, die im Prinzip wie die in Figur 3 gezeigte Struktur ausgebildet ist, angeordnet: Zwischen der oberen AlGaN-Schicht 2o und der unteren GaN-Schicht 2u ist als erste Elektrode das 2DEG 3b-1 angeordnet. Dieses ist seitlich über die Elektrode 3b-2 kontaktiert. Auf der Oberfläche der oberen Schicht 2o befindet sich die flächige Metallelektrode 3a. Durch Anlegen einer elektrischen Spannung bzw. durch Einprägen eines elektrischen Stroms an bzw. in die Elektroden 3a und 3b lässt sich somit die aus den Bauteilen 3a, 3b-1, 3b-2, 2o, 2u und 2p gebildete Membran in Richtung parallel zu den Seitenwänden 1 bzw. senkrecht zur Platinenebene (Platine nicht gezeigt) auslenken (Richtung A).

Das hier gezeigte einfachste Layout beinhaltet nur eine Membran und die zwei Steuerkontakte 3a, 3b (die elektrischen Zuleitungen oder entsprechenden Beschaltungen sind hier nicht gezeigt). Es sind jedoch nahezu beliebige andere Layouts denkbar, wobei runde Membranen bevorzugt werden. Das hier gezeigte Bauelement muss zum Pumpen etwa einer Flüssigkeit abgedichtet auf einen Träger (bzw. auf die nicht gezeigte Platine) aufgebracht werden, wobei dieser Träger bzw. die Platine dann Flüssigkeitsleitungen aufweist. Das gezeigte Bauelement kann dann durch mechanische Anregung Druck von oben auf eine Flüssigkeit ausüben und diese somit pumpen. Geeignete Ausführungen der Kapillarsysteme auf dem Träger bzw. der Platine können dabei auch für eine bestimmte Flussrichtung sorgen.

Eine andere Aufbaumöglichkeit ist der Anbau einer solchen Mikropumpe an ein Röhrchen oder einen Zylinder oder ähnliches, wobei die Seitenwände 1, wie in Figur 20C gezeigt ist, zwischen dem Röhrchen R oder dem Zylinder abgedichtet werden. Dies ist in Figur 20C dadurch realisiert, dass auf der membranabgewandten Seite die Seitenwände 1 auf ihrer Innenseite (d.h. der dem Hohlraum H zugewandten Seite) eine Ausschneidung Z aufweisen, in welche das Röhrchen R oder der Zylinder formschlüssig abdichtend eingepasst bzw. eingeschoben wird. Das Röhrchen R oder der Zylinder kann dann wiederum als Überträger auf ein anderes Kapillarsystem genutzt bzw. aufgebaut werden. Die Ausschneidung Z kann hierbei wie vorbeschrieben als A-daptor-Passung ausgebildet werden, indem die entsprechenden Innenbereiche der Substratwände 1 weggeätzt werden.

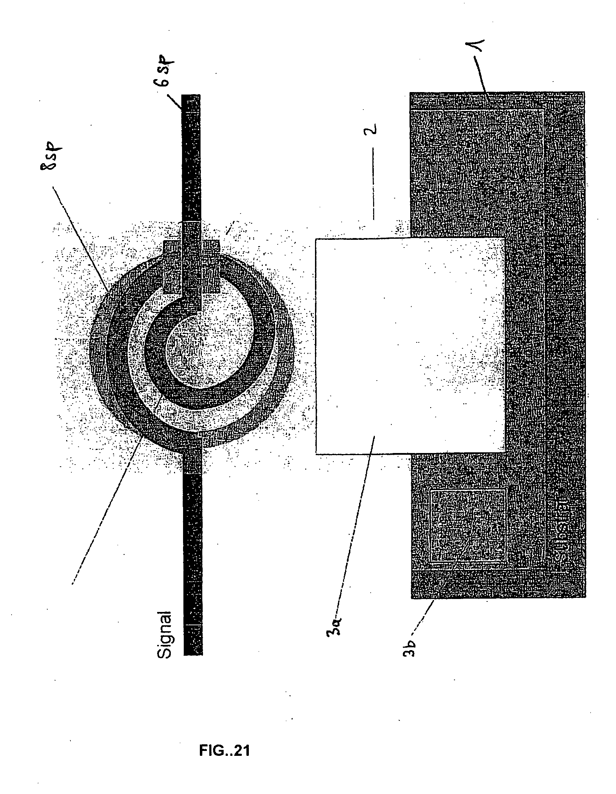

Figur 21 zeigt ein weiteres Ausführungsbeispiel, bei dem der erfindungsgemäße Halbleiteraktor als variable Spule ausgeführt ist. Der grundlegende Aufbau ergibt sich hierbei analog zu dem in Figur 3 gezeigten Aufbau: Freistehender Balken 2 aus einer (partiell) dotierten Gruppe-III-Nitrid-Heterostruktur (etwa AlGaN/GaN), welcher auf seiner Oberseite durch eine metallische Flächenelektrode 3a und an seiner 2DEG-Grenzfläche (nicht gezeigt) seitlich durch eine Elektrode 3b kontaktiert wird. Auf der Unterseite (also der der nicht gezeigten Platine 5 zugewandten Seite) trägt der freistehende Balken 2 auf der der Substratbasis 1 abgewandten Seite eine in Form einer Spulenwicklung aufgebrachte Metallisierung 8sp. Dieser Metallisierung 8sp gegenüber liegend ist auf der Oberfläche der Platine 5 eine entsprechende Metallisierung 6sp aufgebracht. Die auf der Platine 5 angeordnete Signalleitung 6sp weist somit anstatt einer einfachen Leitung eine in der Ebene befindliche Spule auf. Die Metallisierung 6sp kann hierbei (dies gilt ebenso für die auf der Unterseite des Balkens aufgebrachte Metallisierung 8sp) in Form eines Kreises oder einer planaren Spule hergestellt sein. Wird nun, wie vorbeschrieben, der Balken ausgelenkt, so ergibt sich aufgrund der Variation des Abstandes zwischen der Signalleitungsspule 6sp und der auf der Unterseite des Balkens angeordneten Spule 8sp eine Kopplung der magnetischen Felder der beiden Wicklungen 6sp und 8sp; somit verändert sich der Induktionswert L der Anordnung in Abhängigkeit von diesem Abstand. Die Spule 8sp kann hierzu stromdurchflossen sein (es reicht jedoch bereits alleine das Vorhandensein der metallischen Spulenwicklung 8sp).

Die variable Spule kann auch in der sog. "Face-down-Technik" entsprechend Figur 6B realisiert werden. In Bezug auf das Substrat 1 gesehen befindet sich die Spulenwicklung 8sp dann auf der Oberseite des Balkens. Im gezeigten Fall wurde der Balken als AlGaN/GaN-Heterostruktur aufgebaut.

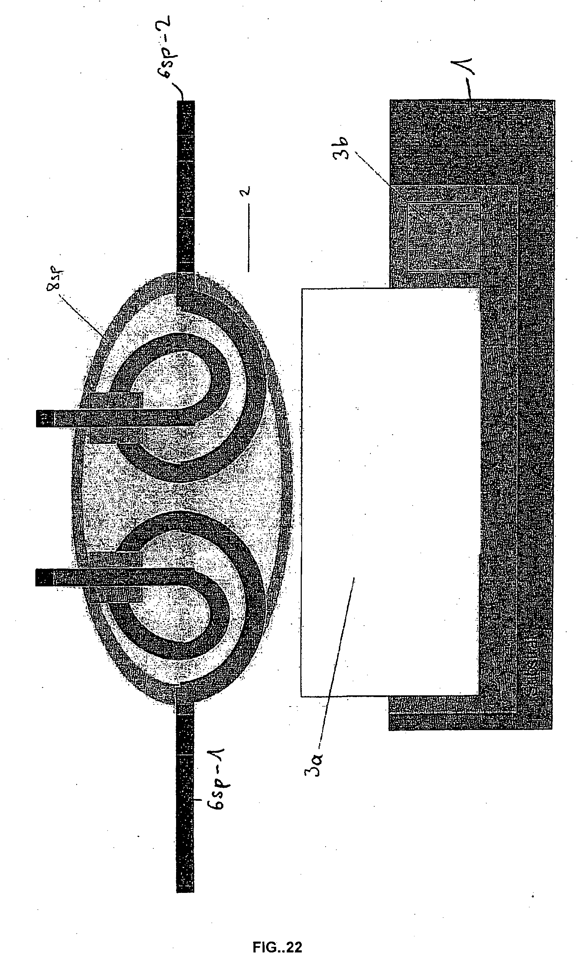

Figur 22 zeigt ein weiteres erfindungsgemäßes Ausführungsbeispiel, in welchem ein variabler Koppler realisiert ist. Der grundsätzliche Aufbau entspricht hierbei dem in Figur 21 gezeigten. Auch bei diesem Ausführungsbeispiel wird die Veränderung des Induktionswertes L durch eine Kopplung von Magnetfeldern ausgenutzt. Bei diesem Ausführungsbeispiel sind im Gegensatz zu dem in Figur 21 gezeigten jedoch auf der Platine 5 seitlich nebeneinander zwei planare Spulen, welche nahe beieinander liegen, jedoch keinen direkten Kontakt (etwa über eine Signalleitung aufweisen), aufgebracht: Die Signalleitung 6sp-1 beinhaltet somit eine erste planare Spule, die daneben liegend angeordnete Signalleitung 6sp-2 eine zweite Spule. Der Balken 2 ist nun so realisiert, dass sein freistehendes Ende die beiden Spulenwicklungen 6sp-1 und 6sp-2 überdeckt: Auf seiner der Platine 5 zugewandten Unterseite weist der Balken an seinem freistehenden Ende eine Spulenwindung 8sp auf, deren Durchmesser mindestens so groß ist, wie der Gesamtdurchmesser der beiden nebeneinander liegenden Spulen 6sp-1, 6sp-2 auf der Platine 5 (würde man die von der Spulenwicklung 8sp umfasst Fläche somit senkrecht auf die Platinenebene projizieren, so überdeckte diese Fläche die von den beiden Spulenwindungen 6sp-1 und 6sp-2 umfasste Gesamtfläche). Durch Verringerung des Abstandes des Balkens 2 über den beiden Spulen 6sp-1, 6sp-2 kann nun eine Kopplung der beiden Spulen 6sp-1, 6sp-2 erreicht werden, wodurch beispielsweise zwei Schaltungen, die an die beiden Signalleitungen angeschlossen sind, verkoppelt werden können.

In einem weiteren Ausführungsbeispiel kann der erfindungsgemäße Aktor auch so ausgebildet sein, dass mit ihm der Nachweis von Substanzen, insbesondere der selektive Nachweis von Gasen und/oder Flüssigkeiten, möglich ist. Hierzu wird zumindest ein Teilbereich der Oberfläche der Biegestruktur 2 mit einer adsorbierenden und/oder absorbierenden Beschichtung versehen. Wird nachfolgend vereinfacht von Adsorption gesprochen, so kann Adsorption und/oder Absorption gemeint sein. Diese Beschichtung ist vorteilhafterweise so aufgebaut, dass sie lediglich die Adsorption bestimmter, vordefinierter Gase oder Flüssigkeiten ermöglicht. Die adsorbierende Beschichtung kann jedoch auch so ausgebildet sein, dass sie generell die Adsorption von Gasen und/oder Flüssigkeiten ermöglicht (nicht selektive Adsorption).

Aufgrund der vorbeschriebenen adsorbierenden Beschichtung ändert sich beim Auftreffen bzw. Anbinden von Gas- und/oder Flüssigkeitsmolekülen von bevorzugt einer bestimmten Sorte an der Oberfläche der Biegestruktur die mechanische Resonanzfrequenz des Aktors: Eine solche Veränderung tritt auf, da sich aufgrund der mit einem Impuls auftreffenden Teilchen rein mechanisch durch Impulsübertrag die Resonanzfrequenz ändert und/oder weil durch chemische Bindung an der Oberfläche (Beschichtung) die Masse und/oder auch das Dipolmoment bzw. die Ladung der Teilchen auf den Aktor einwirken und die Resonanzfrequenz ändern.

Diese Änderung der mechanischen Resonanzfrequenz kann dann wie in Fingerabdruck zum Feststellen derjenigen Teilchensorte verwendet werden, welche sich auf der Oberfläche der Biegestruktur eingelagert hat. Hierzu wird der Aufbau der Biegestruktur so gestaltet, dass das Bauelement auf eine bestimmte Resonanzfrequenz (beispielsweise von 1 MHz) abgestimmt ist, wenn keine zusätzliche Anlagerung von Teilchen erfolgt: Wird somit ohne zusätzlich eingelagerte Teilchen mittels beispielsweise eines Anregungsgenerators das Bauelement so angeregt, dass die Resonanzfrequenz getroffen wird, so kommt es zur maximalen Auslenkung der Biegestruktur. Nach der Anlagerung der Spezies an der Oberfläche ändert sich die Masse der Biegestruktur, so dass sich eine unterschiedliche Resonanzfrequenz ergibt. Bei Beibehaltung der Anregungsbedingungen des Anregungsgenerators verringert sich somit die Auslenkung (keine maximale Auslenkung mehr), was auf dem Fachmann bekannte Art und Weise festgestellt werden kann.

Zur Ermittlung mehrerer Sorten von Teilchen kann auch eine Reihe verschieden beschichteter Elemente verwendet werden. Es kann auch eine Biegestruktur an verschiedenen Stellen unterschiedlich beschichtet werden (da sich die Resonanzfrequenz unterschiedlich ändern wird, je nachdem, wo auf dem Balken Moleküle auftreffen, kann diese Ortsabhängigkeit auch zur Bestimmung der Selektion verwendet werden).

Zudem ist es möglich, einen erfindungsgemäßen Aktor als Schallgeber einzusetzen: Da die Biegestrukturen wie vorbeschrieben auf eine bestimmte Resonanz- oder Betriebsfrequenz angepasst werden können (durch geeignete geometrische Ausgestaltung), kann man diese bei Einprägung einer Wechselspannung definierter Frequenz an den Elektroden 3 prinzipiell auch als Schallsender verwenden.

## Patentansprüche

1. Halbleiteraktor mit
   einer Substratbasis (1),
   einer mit der Substratbasis verbundenen, zumindest teilweise in Bezug auf die Substratbasis auslenkbaren Biegestruktur (2), und
   mindestens zwei Elektroden (3a, 3b) zur Einprägung eines elektrischen Stromes in oder zum Anlegung einer elektrischen Spannung an die Biegestruktur, wobei mindestens zwei der Elektroden beabstandet voneinander jeweils an der Biegestruktur angeordnet und/oder in diese integriert sind,
   wobei die Biegestruktur (2) eine Halbleiter-Heterostruktur aufweist,
   **dadurch gekennzeichnet, dass**
   die Halbleiter-Heterostruktur eine erste Schicht (2u) aus einer Halbleiterverbindung auf Basis eines Nitrids von Hauptgruppe-III-Elementen und eine zweite Schicht (2o) aus einer Halbleiterverbindung auf Basis eines Nitrids von Hauptgruppe-III-Elementen aufweist, welche aneinander angrenzend angeordnet sind, und
   dass zumindest ein Teilabschnitt der Heterostruktur-Grenzfläche zwischen der ersten Schicht (2o) und der zweiten Schicht (2u) als zumindest ein Teilabschnitt einer der Elektroden ausgebildet ist.

2. Halbleiteraktor nach dem vorhergehenden Anspruch
   **dadurch gekennzeichnet, dass**
   die Biegestruktur abschnittsweise (2b) fest mit der Substratbasis verbunden und abschnittsweise (2a) in Bezug auf die Substratbasis freitragend und auslenkbar ist.

3. Halbleiteraktor nach dem vorhergehenden Anspruch
   **dadurch gekennzeichnet, dass**
   die Biegestruktur an zumindest einem Ende ihres freitragenden Bereiches über einen Ankerabschnitt (4) mit der Substratbasis verbunden und auf dieser gelagert ist.

4. Halbleiteraktor nach dem vorhergehenden Anspruch
   **dadurch gekennzeichnet, dass**
   die Biegestruktur an zwei oder mehr Enden ihres freitragenden Bereiches jeweils über einen Ankerabschnitt (4a, 4b) mit der Substratbasis verbunden und auf dieser gelagert ist.

**5.** Halbleiteraktor nach Anspruch 1
*dadurch gekennzeichnet, dass*
die Biegestruktur fest mit der Substratbasis verbunden (2c) ist und an einem von der Substratbasis abgewandten Ende (2d) relativ zur Substratbasis auslenkbar ist.

**6.** Halbleiteraktor nach einem der vorhergehenden Ansprüche,
*dadurch gekennzeichnet, dass*
mindestens eine der Elektroden im oder am freitragenden Abschnitt der Biegestruktur angeordnet ist, wobei bevorzugt eine weitere Elektrode vorhanden ist, die im oder am mit der Substratbasis fest verbundenen Abschnitt der Biegestruktur angeordnet ist, wobei bei Vorhandensein dieser weiteren Elektrode bevorzugt sowohl die am freitragenden Abschnitt angeordnete Elektrode, als auch die am mit der Substratbasis fest verbundenen Abschnitt angeordnete Elektrode auf der Oberseite der Biegestruktur angeordnet ist.

**7.** Halbleiteraktor nach einem der vorhergehenden Ansprüche,
*gekennzeichnet* durch
ein elektrisch leitfähiges Kontaktelement (8) am auslenkbaren Abschnitt der Biegestruktur, insbesondere an einem freitragenden Abschnitt und/oder an einem freistehenden Ende der Biegestruktur.

**8.** Halbleiteraktor nach einem der vorhergehenden Ansprüche,
*gekennzeichnet durch*
mindestens eine Halbleiterverbindung aus GaN, InN, AlN, $Al_xGa_{1-x}N$, $In_xGa_{1-x}N$ und/oder $In_xAl_{1-x}N$ mit einem relativen Elementgehalt von 0<=x<=1.0.

**9.** Halbleiteraktor nach einem der vorhergehenden Ansprüche,
*dadurch gekennzeichnet, dass*
die auslenkbare Biegestruktur eine bei fehlendem eingeprägtem Strom und/oder bei fehlender angelegter Spannung (Ruhelage) mechanisch zug- oder druckverspannte, bevorzugt epitaktisch aufgewachsene Schicht enthält oder daraus besteht und/oder dass die auslenkbare Biegestruktur eine Stresskompensationsschicht aufweist.

**10.** Halbleiteraktor nach einem der vorhergehenden Ansprüche 7 bis 9,
*gekenntzeichnet durch*
einen an oder auf der Substratbasis und/oder an oder auf einer angrenzend an die Substratbasis angeordneten Struktur (5), insbesondere einer Platine, angeordneten elektrischen Kontakt (6), wobei der elektrische Kontakt und die Biegestruktur so angeordnet sind, dass der elektrische Kontakt durch Auslenkung der Biegestruktur mittels des Kontaktelementes (8) schließbar ist.

**11.** Halbleiteraktor nach einem der vorhergehenden Ansprüche 7 bis 10,
*gekennzeichnet durch*
einen an oder auf der Substratbasis und/oder an oder auf einer angrenzend an die Substratbasis angeordneten Struktur (5), insbesondere einer Platine, angeordnetes leitfähiges Gegenelement (6), wobei das leitfähige Gegenelement und die Biegestruktur so angeordnet und/oder ausgebildet sind, dass bei Auslenkung der Biegestruktur durch einen vordefinierten eingeprägten Strom oder **durch** eine vordefinierte eingeprägte Spannung der Abstand vom elektrisch leitfähigen Kontaktelement (8) zum Gegenelement einen vordefinierten Wert aufweist.

**12.** Halbleiteraktor nach einem der vorhergehenden Ansprüche,
*dadurch gekennzeichnet, dass*
zumindest ein Teilabschnitt des auslenkbaren, freitragenden Teils (2a) der Biegestruktur (2) als Membran so ausgeformt ist, dass durch Einprägen eines zeitlich veränderlichen Stromes oder durch Anlegen einer zeitlich veränderbaren Spannung an mindestens zwei der Elektroden mit der Membran im wesentlichen senkrecht zur in der Ruhelage gegebenen Membranebene eine zeitlich veränderliche Auswölbungsbewegung durchführbar ist.

**13.** Verwendung eines Halbleiteraktors nach einem der vorhergehenden Halbleiteraktoransprüche als mikromechanischer Varaktor, zur Veränderung einer Kapazität, als mikromechanisches elektrisches Schaltelement oder als mikromechanische Pumpe.

**Claims**

**1.** A semiconductor actuator, comprising:

a substrate base (1);
a bending structure (2) connected to the substrate base and deflectable at least partially relative to the substrate base; and
at least two electrical supply contacts (3a, 3b) for impressing an electrical current in or for applying an electrical voltage to the bending structure, wherein at least two of the electrical supply contacts are disposed at a spacing from each other respectively on the bending structure and/or integrated into the bending structure, wherein the bending structure (2) comprises of a semiconductor hetero-structure,
**characterised in that**
the semiconductor hetero-structure comprises a first layer (2u) of a semiconductor compound on the basis of nitrides of main group III elements and a second layer (2o) of a semiconductor compound on the basis of nitrides of main group III elements, which are arranged adjacently to each other, and

that at least a partial portion of the hetero-structure bounding surface between the first layer and the second layer is designed as at least a partial portion of one of the electrical supply contacts.

2. Semiconductor actuator according to the preceding claim **characterised in that** the bending structure is securely connected in selected portions (2b) to the substrate base, and the bending structure is cantilevered and deflectable in further selected portions (2a) relative to the substrate base.

3. Semiconductor actuator according to the preceding claim **characterised in that** the bending structure is at least connected at one end of the cantilevered region thereof via an anchor portion (4) to the substrate base and supported thereon.

4. Semiconductor actuator according to the preceding claim **characterised in that** the bending structure is connected at two or more ends of the cantilevered region thereof respectively via an anchor portion (4a, 4b) to the substrate base and is supported thereon.

5. Semiconductor actuator according to claim 1, **characterised in that** the bending structure is securely connected (2c) to the substrate base and is deflectable relative to the substrate base at one end (2d) which is orientated away from the substrate base.

6. Semiconductor actuator according to one of the preceding claims **characterised in that** at least one of the electrical supply contacts is disposed in or on the cantilevered portion of the bending structure, wherein preferably a further electrical supply contact is disposed in or on the portion of the bending structure which is securely connected to the substrate base, wherein the at least one electrical supply contact and the further electrical supply contact are arranged on the upper side of the bending structure.

7. Semiconductor actuator according to one of the preceding claims **characterised by** an electrically conductive contact element (8) on the deflectable portion of the bending structure, in particular on a cantilevered portion and/or on a free-standing end of the bending structure.

8. Semiconductor actuator according to one of the preceding claims **characterised by** at least one semiconductor compound made of GaN, InN, AlN, $Al_xGa_{1-x}N$, $In_xGa_{1-x}N$ and/or $In_xAl_{1-x}N$ with a relative element content of $0 \leq x \leq 1.0$.

9. Semiconductor actuator according to one of the preceding claims **characterised in that** the deflectable bending structure comprises or consists of a preferably epitaxially grown layer which, with a lack of impressed current and/or with a lack of applied voltage (inoperative position), is mechanically strained in tension or pressure, and/or **in that** the deflectable bending structure has a stress compensation layer.

10. Semiconductor actuator according to one of the preceding claims 7 to 9, **characterised by** an electrical contact (6) which is disposed at or on the substrate base and/or at or on a structure (5) which is disposed abutting against the substrate base, in particular a circuit board, the electrical contact and the bending structure being disposed such that the electrical contact is closable by deflecting the bending structure by means of the electrically conductive contact element (8).

11. Semiconductor actuator according to one of the preceding claims 7 to 10, **characterised by** a conductive counter-element (6) which is disposed at or on the substrate base and/or at or on a structure (5) which is disposed abutting against the substrate base, in particular a circuit board, the conductive counter-element and the bending structure being disposed and/or configured such that, when deflecting the bending structure by means of a predefined impressed current or by a predefined impressed voltage, the spacing of the electrically conductive contact element (8) relative to the counter-element has a predefined value.

12. Semiconductor actuator according to one of the preceding claims **characterised in that** at least a partial portion of the deflectable cantilevered part (2a) of the bending structure (2) is formed as a membrane such that, by impressing a temporally variable current or by applying a temporally variable voltage to at least two of the supply contacts with the membrane essentially perpendicular to the membrane plane which pertains in the inoperative position, a temporally variable curving movement is realisable.

13. Use of a semiconductor actuator according to one of the preceding semiconductor actuator claims as micromechanical varactor for changing a capacitance, as micromechanical electrical switching element or as micromechanical pump.

**Revendications**

1. Actionneur à semi-conducteurs comportant :

une base de substrat (1),
une structure flexible (2) reliée à la base de substrat, pouvant être fléchie au moins partiellement par rapport à la base de substrat, et

au moins deux électrodes (3a,3b) pour appliquer un courant électrique dans ou pour appliquer une tension électrique à la structure flexible, dans lequel au moins deux des électrodes sont disposées respectivement sur la structure flexible et/ou intégrées dans celle-ci en étant espacées l'une de l'autre,

dans lequel la structure flexible (2) présente une structure hétérogène à semiconducteurs,

**caractérisé en ce que**

la structure hétérogène à semi-conducteurs présente une première couche (2u) d'une liaison semi-conductrice à base d'un nitrure d'éléments du groupe principal III et une deuxième couche (2o) d'une liaison semi-conductrice à base d'un nitrure d'éléments du groupe principal III, qui sont disposées à proximité l'une de l'autre, et au moins une portion partielle de l'interface à structure hétérogène entre la première couche (2u) et la deuxième couche (2o) est conçue comme au moins une portion partielle d'une des électrodes.

2. Actionneur à semi-conducteurs selon la revendication précédente,
   **caractérisé en ce que**
   la structure flexible est solidement reliée à la base de substrat sur des portions (2b) et est en porte-à-faux et peut être fléchie sur des portions (2a) par rapport à la base de substrat.

3. Actionneur à semi-conducteurs selon la revendication précédente,
   **caractérisé en ce que**
   la structure flexible est reliée à au moins une extrémité de sa région en porte-à-faux par l'intermédiaire d'une portion d'ancrage (4) à la base de substrat et est positionnée sur celle-ci.

4. Actionneur à semi-conducteurs selon la revendication précédente,
   **caractérisé en ce que**
   la structure flexible est reliée à la base de substrat à deux ou plus de deux extrémités de sa région en porte-à-faux respectivement par l'intermédiaire d'une portion d'ancrage (4a, 4b) et est positionnée sur celle-ci.

5. Actionneur à semi-conducteurs selon la revendication 1,
   **caractérisé en ce que**
   la structure flexible est reliée (2c) solidement à la base de substrat et peut être fléchie par rapport à la base de substrat à une extrémité (2d) qui se détourne de la base de substrat.

6. Actionneur à semi-conducteurs selon une des revendications précédentes,
   **caractérisé en ce que**
   au moins une des électrodes est disposée dans ou sur la portion en porte-à-faux de la structure flexible, dans lequel de préférence une électrode supplémentaire est présente, qui est disposée dans ou sur la portion de la structure flexible reliée solidement à la base de substrat, dans lequel en présence de cette électrode supplémentaire de préférence tant l'électrode disposée sur la portion en porte-à-faux que l'électrode disposée sur la portion solidement reliée à la base de substrat est disposée sur la face supérieure de la structure flexible.

7. Actionneur à semi-conducteurs selon une des revendications précédentes,
   **caractérisé par**
   un élément de contact (8) électriquement conducteur sur la portion pouvant être fléchie de la structure flexible, notamment sur une portion en porte-à-faux et/ou sur une extrémité découverte de la structure flexible.

8. Actionneur à semi-conducteurs selon une des revendications précédentes,
   **caractérisé par**
   au moins une liaison à semi-conductrice en GaN, InN, AlN, $Al_xGa_{1-x}N$, $In_xGa_{1-x}N$ et/ou $In_xA_{1-x}N$ avec une teneur en élément relative de $0<=x<=1.0$.

9. Actionneur à semi-conducteurs selon une des revendications précédentes,
   **caractérisé en ce que**
   la structure flexible pouvant être fléchie contient ou est constituée d'une couche obtenue de préférence par croissance épitaxiale, contrainte mécaniquement par traction ou pression en l'absence de courant appliqué et/ou en l'absence de tension appliquée (position de veille) et/ou **en ce que** la structure flexible pouvant être fléchie présente une couche de compensation du stress.

10. Actionneur à semi-conducteurs selon une des revendications précédentes 7 à 9,
    **caractérisé par**
    un contact électrique (6) disposé contre ou sur la base de substrat et/ou contre ou sur une structure (5) disposée à proximité sur la base de substrat, notamment une platine, dans lequel le contact électrique et la structure flexible sont disposés de telle sorte que le contact électrique puisse être fermé par flexion de la structure flexible au moyen de l'élément de contact (8).

11. Actionneur à semi-conducteurs selon une des revendications précédentes 7 à 10,
    **caractérisé par**

un élément opposé conducteur (6) disposé contre ou sur la base de substrat et/ou contre ou sur une structure (5) disposée à proximité sur la base de substrat, notamment une platine, dans lequel l'élément opposé conducteur et la structure flexible sont disposés et/ou conçus de telle sorte que lors de la flexion de la structure flexible par un courant appliqué prédéflni ou par une tension appliquée prédéfinie, l'espacement entre l'élément de contact (8) électriquement conducteur et l'élément opposé présente une valeur prédéfinie.

12. Actionneur à semi-conducteurs selon une des revendications précédentes,
**caractérisé en ce que**
au moins une portion partielle de la partie en porte-à-faux (2a) pouvant être fléchie de la structure flexible (2) est façonnée comme une membrane, de telle sorte que par l'application d'un courant variable temporellement ou par l'application d'une tension variable temporellement sur au moins deux des électrodes avec la membrane essentiellement perpendiculaire au plan de membrane placé dans la position de veille, un movement de bombement variable temporellement peut être exécuté.

13. Utilisation d'un actionneur à semi-conducteurs selon une des revendications précédentes comme varactor micromécanique, pour modifier une capacité, comme élément de commutation électrique micromécanique ou comme pompe micromécanique.

**Fig. 1**

Fig. 2

**Fig. 3**

EP 2 018 673 B1

Fig. 4

**Fig. 5**

Fig. 6A

**Fig. 6B**

Fig. 7A

**Fig. 7B**

**Fig. 7C**

**FIG..7D**

AlN (Cap)                                                    2-3

Übergangs-/Zwischenschicht                                   2-2

                                                             2-1

GaN (Puffer)

**Fig. 8**

EP 2 018 673 B1

**Fig. 9**

**Fig. 10**

EP 2 018 673 B1

Fig. 11

**Fig. 12**

EP 2 018 673 B1

**Fig. 13**

Fig. 14

EP 2 018 673 B1

A

2-1

3b

isolierendes Gr-III-N

2d    2-2

isolierendes Gr-III-N

3a

E

2c

1

B

2d    RL

Starrer
Teil 2-1

3b

D

E

2-2

3a

1

2c

2d    RL

C

Starrer
Teil

3b

3a

2-2

2c

**Fig. 15**

**Fig. 16**

EP 2 018 673 B1

Fig. 17

**Fig. 18**

EP 2 018 673 B1

Fig. 19

FIG..20

FIG..21

FIG..22

## EP 2 018 673 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2004083110 A2

- US 20030119220 A1